# FASCICULE DE BREVET EUROPEEN

(11) **EP 2 782 886 B1**
(45) Date de publication et mention de la délivrance du brevet: **27.04.2016**
(21) Numéro de dépôt: 12795394.1
(22) Date de dépôt: 23.11.2012
(51) Int. Cl.: C04B 41/89, C23C 16/02, C23C 16/32

(54) **PROCÉDÉ POUR REVÊTIR UNE PIÈCE D'UN REVÊTEMENT DE PROTECTION CONTRE L'OXYDATION PAR UNE TECHNIQUE DE DÉPÔT CHIMIQUE EN PHASE VAPEUR, ET REVÊTEMENT ET PIÈCE**
BESCHICHTUNGSVERFAHREN MITTELS EINER CHEMISCHEN DAMPFABSCHEIDUNGSTECHNIK, BAUTEIL MIT EINER BESCHICHTUNG ZUM SCHUTZ GEGEN OXIDATION SOWIE BESCHICHTUNG UND BAUTEIL
METHOD FOR COATING, USING A CHEMICAL VAPOR DEPOSITION TECHNIQUE, A PART WITH A COATING FOR PROTECTING AGAINST OXIDATION, AND COATING AND PART

(30) Priorité: 25.11.2011 FR 1160815
(43) Date de publication de la demande: 01.10.2014
(73) Titulaire: Commissariat à l'Énergie Atomique et aux Énergies Alternatives, 75015 Paris (FR); Centre National de la Recherche Scientifique, 75016 Paris (FR)
(72) Inventeur: ALLEMAND, Alexandre, F-33000 Bordeaux (FR); SZWEDEK, Olivier, F-37170 Chambray-les-Tours (FR); EPHERRE, Jean-François, F-40410 Saugnac et Muret (FR); LE PETITCORPS, Yann, F-33850 Léognan (FR)
(74) Mandataire: Ahner, Philippe
(86) Numéro de dépôt international: PCT/EP2012/073524
(87) Numéro de publication internationale: WO 2013/076274

(56) Documents cités:
- US-A- 5 283 109
- US-B2- 6 582 779
- DATABASE WPI Week 201167 Thomson Scientific, London, GB; AN 2011-M14927 XP002679688, & CN 102 167 623 A (LIAO J) 31 août 2011 (2011-08-31)

## Description

### DOMAINE TECHNIQUE

L'invention a trait à un procédé pour revêtir une pièce d'un revêtement de protection contre l'oxydation par une technique de dépôt chimique en phase vapeur *(« Chemical Vapour Déposition* » ou CVD en anglais).

Plus précisément, l'invention a trait à un procédé pour revêtir au moins une surface d'au moins une pièce en au moins un matériau susceptible d'être oxydé, par un revêtement de protection contre l'oxydation.

L'invention a également trait à un revêtement de protection contre l'oxydation et à une pièce pourvue d'un tel revêtement.

Le domaine technique de l'invention peut être défini de manière générale comme celui de la protection à l'oxydation ou PAO.

Le domaine technique de l'invention est en particulier celui de la protection contre l'oxydation à haute température, généralement à une température supérieure à 1200°C, de matériaux sensibles à l'oxydation, tels que les matériaux composites et notamment les matériaux composites carbone/carbone.

### ÉTAT DE LA TECHNIQUE ANTÉRIEURE.

Les matériaux composites tels que les matériaux composites carbone/carbone (C/C) sont connus depuis plus de trente ans pour leur excellente tenue en température et leur résistance aux chocs thermiques. Ils conservent leur contrainte à la rupture et leur module à des températures supérieures à 2000°C. Cependant, dans le cadre d'une utilisation prolongée en milieu oxydant, ils perdent rapidement toute propriété mécanique, et cela dès 400°C. C'est pour pallier à ce problème majeur qu'il y a une vingtaine d'années, ont été mis au point les composites à matrice SiC et à fibres de C, tout d'abord, puis à fibres de SiC quand ces dernières furent disponibles sur le marché. Cependant, si les composites SiC/SiC ou C/SiC présentent une meilleure tenue à l'oxydation que les composites C/C, ils ne peuvent pas être utilisés à des températures supérieures à 1200°C.

Les revêtements de protection à l'oxydation des matériaux à base de C, et notamment des matériaux composites C/C peuvent être de différentes natures chimiques.

On distingue notamment les revêtements à base de métaux nobles, les revêtements à base de phosphates ; les revêtements à base d'oxyde de bore, de borates ou de borures ; les revêtements à base de carbures.

Nous nous intéressons tout d'abord aux revêtements à base de métaux nobles.

Parmi les métaux nobles, l'iridium est particulièrement intéressant en tant que protection à l'oxydation (PAO), à cause de sa température de fusion élevée (2440°C) et de sa très faible perméabilité à l'oxygène jusqu'à environ 2100°C.

Au cours des années 60, l'iridium a été particulièrement étudié dans le cadre du programme spatial des États-Unis [1]. Le principal problème qui se pose lors l'utilisation de l'iridium afin de réaliser une PAO est l'extrême volatilité des oxydes d'iridium (IrO₂ et IrO₃).

De plus, la différence de coefficient de dilatation entre l'iridium et le carbone rend l'obtention d'une PAO adhérente difficile.

Cependant, des dépôts denses d'iridium, adhérents au carbone ont été obtenus.

Ainsi, le document [2] décrit un procédé comprenant tout d'abord le dépôt d'une barbotine de poudre d'iridium finement divisée sur un substrat en graphite, puis le chauffage du substrat de graphite revêtu à une température supérieure à 2130°C et pendant une durée suffisante pour obtenir un revêtement en iridium fondu contenant du graphite recristallisé.

Le document [3] décrit un procédé pour réaliser un revêtement en iridium sur un substrat en graphite dans lequel on dépose une barbotine de poudre d'iridium sur un substrat en graphite, puis on chauffe le substrat en graphite pour produire par frittage un revêtement d'iridium aggloméré sur ce substrat en graphite, ce revêtement présentant, par exemple, une épaisseur d'environ 60 µm. On procède ensuite à un dépôt en phase vapeur d'iridium sur le revêtement d'iridium aggloméré, par exemple par sublimation d'iridium carbonyle ou chlorocarbonyle dans une atmosphère d'oxyde de carbone sous pression réduite entre 300°C et 800°C. L'épaisseur du dépôt d'iridium ainsi réalisé est par exemple d'environ 15 µm. On réalise enfin un dépôt par galvanoplastie d'une couche d'iridium sur l'iridium déposé en phase vapeur.

Il est possible d'estimer l'épaisseur du dépôt final à environ 100 µm.

La PAO préparée dans le document [3] a été testée et elle résiste à l'oxydation dans l'air, par exemple jusqu'à 2000°C, pendant 10 minutes, sans dégradation.

Par ailleurs selon le document [1], le taux de récession de l'iridium sous air à 2000°C à pression atmosphérique est d'environ 150 µm/heure.

En conclusion, les inconvénients des PAO à base de métaux nobles comme l'iridium sont principalement le coût, et la formation d'espèces volatiles, telles que IrO₂ et IrO₃, très instables.

Une autre catégorie de revêtements de protection contre l'oxydation est constituée par les revêtements à base de phosphates.

Des émaux à base de phosphates sont souvent décrits dans la littérature, et notamment dans le document [1], pour la protection de matériaux carbonés.

Le document [4] décrit un procédé pour réaliser la protection contre l'oxydation d'un produit en matériau composite comprenant du carbone et présentant une surface céramique dans lequel on forme sur la surface céramique un revêtement externe avec une composition à base de P₂O₅-SiO₂-Al₂O₃, et après séchage, on réalise un traitement thermique à une température au moins suffisante pour transformer le revêtement externe en un ciment insoluble susceptible de former un verre auto-cicatrisant.

Ce type de protection à base de phosphates est, selon le document [1], efficace pour des températures allant jusqu'à 1000°C.

L'inconvénient principal des PAO à base de phosphates est qu'ils n'assurent une protection qu'à des températures inférieures à 1200°C.

D'autres revêtements de PAO sont les revêtements à base d'oxyde de bore, de borates ou de borures.

Les revêtements à base de borure de zirconium (ZrB₂) sont, selon le document [1], efficaces pour protéger, sur un temps très court, du graphite jusqu'à 2200°C.

L'oxyde de bore peut également être employé pour assurer la cohésion de particules réfractaires telles que ZrB₂, HfB₂ ou ZrSi₂ afin de former un revêtement imperméable à la surface du matériau. Après 10 heures sous air à 1200°C, un composite C/C revêtu d'une telle protection est, selon le document [5], toujours intègre.

L'inconvénient principal des PAO à base de borates, borures, ou oxydes de bore est qu'il y a toujours formation de B₂O₃ qui se volatilise dès 1200°C.

Les revêtements de PAO peuvent également être à base de carbures.

Le carbure de silicium (SiC) est très intéressant pour réaliser des PAO résistant à de hautes températures, par exemple supérieures à 1200°C, car il forme avec l'oxygène de l'air un oxyde qui, au-delà de 1300°C, a la plus faible perméabilité à l'oxygène de tous les oxydes [1].

De plus, dans certaines conditions de température et de pression partielle d'O₂ le SiC forme une phase vitreuse qui permet, en nappant le carbone, de boucher les pores et les fissures éventuelles.

Cette PAO semble efficace entre 1000°C et 1800°C [1] en fonction de la pression partielle d'oxygène.

Le dépôt chimique en phase vapeur (« *Chemical Vapour Deposition »* ou CVD en anglais) est le moyen le plus couramment employé pour déposer du SiC en vue de réaliser une PAO [1].

Le document [6] décrit des pièces en matériaux réfractaires préparés par compression à chaud de poudres de TiB₂, ZrB₂, HfB₂, NbB₂, TaB₂ ou de mélanges de ceux-ci et de 10% à 35% en volume de SiC. Un matériau préféré est préparé par compression à chaud de poudres de ZrB₂ et de SiC. Ces matériaux présentent une bonne résistance à l'oxydation, aux contraintes thermiques, et à l'ablation, et possèdent une bonne intégrité mécanique.

Le document [7] a trait à des compositions de céramique composites qui résistent à l'ablation à haute température et qui peuvent notamment être utilisées pour la protection thermique extérieure de véhicules spatiaux tels que les navettes spatiales.

Ces compositions comprennent notamment des mélanges de diborure de zirconium et de carbure de zirconium avec du carbure de silicium, des mélanges de diborure de hafnium et de carbure de hafnium avec du carbure de silicium et des mélanges de diborures et/ou carbures de zirconium et de hafnium avec du carbure de silicium.

Ces céramiques sont préparées par frittage sous pression d'un mélange de poudres à une température qui va généralement de 1850°C à 2250°C.

Différentes compositions sont testées sous différents flux thermiques.

La composition constituée de ZrC (20%vol), ZrB₂ (16%vol) et le reste de SiC, présente, sous un flux de 400W/cm², sous une pression de 0,075 atm et à une température de 2180°C, un taux d'ablation de 1,97 µm/min. Il s'agit-là du meilleur résultat obtenu dans le document [7], en condition d'oxydation active de SiC.

Le document [8] décrit un revêtement en carbure réfractaire pour une surface d'un substrat en carbone, soumise à des contraintes de température et d'abrasion telles que des cols de tuyères, des aubes de turbines, des boucliers thermiques et des « structures hypersoniques ».

Le substrat en carbone peut être en carbone pyrolytique, ou en un composite carbone-carbone.

Le revêtement est préparé en chauffant le substrat dans un four sous vide et en introduisant un halogénure d'un métal formant un carbure dans le four. Le métal forme un carbure avec le carbone sur une première partie de la surface du substrat. Ensuite, un hydrocarbure gazeux est ajouté à l'halogénure et une couche continue de carbure est ainsi formée sur la première partie.

Le carbure préféré est le carbure d'hafnium HfC, mais le carbure de silicium SiC, le carbure de tantale TaC, le carbure de zirconium ZrC, et les carbures mixtes de silicium, tantale ou zirconium avec l'hafnium peuvent aussi être utilisés.

Cette couche de carbure résiste à la fissuration et à l'écaillage.

Il est à noter que, selon le document [1], le carbure le plus réfractaire, qui est le HfC, semble protéger le carbone jusqu'à 1300°C.

Une autre technique également utilisée pour déposer des couches de carbure est la technique dite de « *pack cementation ».*

Cette technique, qui est notamment décrite dans le document [9], consiste à préparer un mélange d'une poudre de métal réfractaire (par exemple du chrome), d'un oxyde de métal (par exemple de l'alumine) et d'un catalyseur (par exemple du chlorure d'ammonium).

Le mélange est ensuite mis en contact avec la pièce en carbone à revêtir, et l'ensemble formé par la pièce et le mélange est porté à une température de 1000°C sous argon. Le métal réagit alors avec le substrat pour former une couche de carbure.

L'inconvénient principal des PAO à base de carbures est qu'il est obligatoire dans ces PAO d'associer plusieurs carbures.

En effet, aucun carbure ne peut, à lui seul, assurer une tenue à une température élevée et une faible oxydation du substrat.

D'autres revêtements de PAO, encore, sont les revêtements multicouches.

En effet, d'une manière générale, une PAO constituée par un seul composé chimique est inopérante à haute température, c'est-à-dire une température généralement supérieure à 1200°C.

Il est, en effet, préférable pour pallier aux problèmes de diffusion de l'oxygène, de compatibilité avec le carbone, et d'accord des coefficients de dilatation, de réaliser une PAO multicouche ou multi-séquencée.

Le document [10] décrit une structure réfractaire capable de résister de manière prolongée à des températures dépassant au moins environ 2500°F dans un environnement oxydant qui comprend un substrat composite carbone-carbone résistant aux températures élevées et un revêtement résistant à l'oxydation à haute température (à savoir une PAO) formé *in situ* sur la surface du substrat et comprenant des couches minces alternées de SiC et d'un carbure d'un métal du groupe IVB, tel que HfC ou ZrC. Ces couches alternées ont une épaisseur de 1 à 10 µm et l'épaisseur totale de la PAC est d'environ 130 à 500 µm.

La couche au contact du CIC est de préférence du SiC.

La réalisation de ces couches se fait par dépôt chimique en phase vapeur (« CVD ») à une température comprise entre environ 1090°C et 1400°C (plus précisément à une température d'environ 1198°C) sous une pression comprise entre environ 6 mbar et 667 mbar (plus précisément à une pression d'environ 26 mbar).

Le précurseur du SiC est le méthyltrichlorosilane (MTS) et celui du HfC est le tétrachlorure d'hafnium obtenu par balayage de chlore sur de l'hafnium métal à 510°C. L'alternance des couches est obtenue en ouvrant ou en coupant l'arrivée de chlore toutes les 2 minutes.

Les auteurs indiquent qu'une telle PAO protège efficacement un C/C pendant plusieurs heures à 1760°C. Pour des temps plus courts de protection, celle-ci tient jusqu'à 1930°C.

La préparation de revêtements multicouche notamment par un procédé de dépôt chimique en phase vapeur, est cependant longue, complexe et coûteuse, elle nécessite de multiples étapes et un appareillage compliqué.

Par ailleurs, on connaît des procédés de préparation de fibres courtes encore appelées « trichites » ou « whiskers », notamment de SiC.

D'une manière générale, le procédé utilisé pour faire croître des whiskers de SiC c'est-à-dire des monocristaux courts, fins, allongés, typiquement de 5 à 80 µm de longueur, et de 0,4 à 0,7 µm de diamètre, est un procédé de dépôt chimique en phase vapeur (« *Chemical Vapour Deposition* », ou « CVD » en anglais) ou un procédé d'infiltration chimique en phase vapeur (« *Chemical Vapour Infiltration* » ou « CVI » en anglais) mis en oeuvre en présence de catalyseurs ou de solvants.

En général, comme catalyseur on utilise des métaux de transition Fe, Ni, Cr, Mn... ou bien d'autres éléments tels que Al, ou La qui peuvent se trouver sous des formes chimiques diverses, par exemple sous la forme d'oxydes de ces métaux ou éléments.

Comme solvant, on utilise généralement de l'eau ou de l'éthanol.

Le rôle du catalyseur ou du solvant est de former au cours du processus de CVD/CVI une solution sous la forme d'une masse fondue, de type Me-Si-C, Me représentant le métal ou les métaux jouant le rôle de solvant ou catalyseur, dans laquelle sont présents du silicium et du carbone.

Dans ces conditions, le dépôt chimique en phase vapeur a lieu de façon prédominante à la surface des gouttelettes de masse fondue selon le mécanisme dit VLS *(« Vapour-Liquid-Solid Process* » en anglais), ce qui assure la croissance axiale du SiC.

Ainsi, le document FR-A1-2716208 [11] décrit un procédé de préparation de trichites ou whiskers de carbure de silicium, et plus particulièrement de trichites ou de whiskers de carbure de silicium pouvant atteindre par exemple jusqu'à 100 mm, et de mats de ceux-ci, sur un substrat, par traitement thermique, à une température de 1250°C à 1500°C, d'un mélange gazeux comprenant de l'hydrogène et des sources d'atomes de Si et de C qui sont sous la forme d'au moins un composé dépourvu d'oxygène, en présence d'un catalyseur choisi dans le groupe des métaux. Lors de la période de croissance de ce procédé, un catalyseur à deux composants, Al-Fe, est introduit dans la phase gazeuse dans la zone de réaction, au moyen d'une réduction par le carbone de céramiques de type aluminosilicate, lesquelles céramiques comprennent au moins 73% en poids d'alumine et de 0,3% à 3% en poids d'oxydes de fer; et le substrat est un tissu de carbone à base de fibre de rayonne carbonisée, lequel tissu a été prétraité avant la carbonisation, par une solution de borax et une solution de phosphate de diammonium jusqu'à ce que la quantité de bore dans le tissu n'atteigne pas plus de 4% en poids et que la quantité de phosphore n'atteigne pas plus de 2% en poids.

Les trichites ou whiskers préparés sont facilement séparés du substrat de croissance.

Il est précisé que les trichites ou whiskers préparés peuvent être utilsés comme matériaux de renforcement par incorporation dans des composites à base de métaux, des céramiques industrielles, des outils de coupe en céramique, des isolants thermiques etc.

Le document [11] a donc essentiellement trait à un procédé de préparation de trichites ou whiskers de SiC, et à la récupération de ces trichites ou whiskers à l'issue du procédé en vue De leur utilisation ultérieure.

Le revêtement de ces trichites ou whiskers par une autre céramique n'est ni décrit ni suggéré dans ce document.

De la même manière, la mise en oeuvre de ces trichites ou whiskers pour préparer un revêtement pour la PAO, et notamment pour constituer la première couche d'un revêtement de PAO multicouche n'est ni décrite, ni suggérée dans le document [11].

Le document [12] divulgue un substrat en matériau carbone/carbone pourvu d'un revêtement constitué par une alternance de couches de SiC et de HfC.

Le document [13] divulgue un composite carbone/carbone, qui est revêtu d'une première couche de whiskers de carbure de silicium formée sur une couche de catalyseur préalablement déposée comprenant le nickel et l'aluminium, puis avec une deuxième couche de carbure de silicium.

Il existe donc au vu de ce qui précède, un besoin pour un procédé de préparation d'un revêtement multicouche de protection contre l'oxydation sur une pièce en un matériau susceptible d'être oxydé, ce revêtement étant un revêtement conférant une protection contre l'oxydation aux hautes températures, supérieures par exemple à 1200°C, et pouvant aller jusqu'à 2000°C, voire 2500°C, pendant une durée prolongée, pouvant atteindre plusieurs minutes, par exemple 10 minutes.

Il existe en d'autres termes, un besoin pour un procédé de préparation d'un revêtement de protection contre l'oxydation qui soit également réfractaire, voire très réfractaire.

Il existe en particulier un besoin pour un procédé de préparation d'un revêtement qui assure une protection efficace contre l'oxydation, aux températures élevées, de pièces en matériaux composites carbone-carbone.

Il existe encore un besoin pour un tel procédé d'un revêtement multicouche qui soit simple, fiable, rapide, peu coûteux, et qui permette d'obtenir un revêtement de qualité, dense et autant que possible exempt de fissures.

Le but de l'invention est de fournir un procédé pour préparer un revêtement multicouche de protection contre l'oxydation sur au moins une surface d'au moins une pièce en au moins un matériau susceptible d'être oxydé qui réponde entre autre à ce besoin et qui ne présente pas les inconvénients, défauts, limitations et désavantages des procédés de l'art antérieur et qui résolve les problèmes des procédés de l'art antérieur.

### EXPOSÉ DE L'INVENTION

Ce but, et d'autres encore, sont atteints, conformément à l'invention, par un procédé pour préparer un revêtement multicouche de protection contre l'oxydation sur au moins une surface d'au moins une pièce en au moins un matériau susceptible d'être oxydé, dans lequel on réalise les étapes successives suivantes :
a) on dépose sur la surface une couche d'un catalyseur permettant la croissance de fibres courtes en une céramique qui résiste à l'oxydation ;
b) On fait croître sur la surface, par un procédé de dépôt chimique en phase vapeur CVD ou un procédé d'infiltration chimique en phase vapeur CVI, une première couche constituée par des particules d'une céramique qui résiste à l'oxydation, lesdites particules comprenant une majorité de fibres courtes en une céramique qui résiste à l'oxydation ;
c) on revêt la première couche par un procédé de dépôt chimique en phase vapeur CVD ou un procédé d'infiltration chimique en phase vapeur CVI, de manière totalement homogène, fibre à fibre et sans laisser de porosité, par une deuxième couche en une céramique réfractaire ;
d) on revêt la deuxième couche, par un procédé de dépôt chimique en phase vapeur CVD ou un procédé d'infiltration chimique en phase vapeur CVI, par une troisième couche en une céramique qui résiste à l'oxydation ;
e) éventuellement, on revêt la troisième couche, par un procédé de dépôt chimique en phase vapeur CVD ou un procédé d'infiltration chimique en phase vapeur CVI, par une quatrième couche en une céramique réfractaire ;
f) éventuellement on revêt la quatrième couche, par un procédé de dépôt chimique en phase vapeur CVD ou un procédé d'infiltration chimique en phase vapeur CVI, par une cinquième couche en une céramique qui résiste à l'oxydation ;
g) éventuellement on répète de 1 à 100 fois, de préférence de 1 à 50 fois, les étapes e) et f) ;
h) on récupère la pièce, revêtue sur au moins une de ses surfaces par un revêtement réfractaire de protection contre l'oxydation, ledit revêtement présentant une microstructure tridimensionnelle jusqu'à la troisième couche ou jusqu'à la cinquième couche éventuelle ; la céramique qui résiste à l'oxydation étant différente de la céramique réfractaire.

Plus exactement, on pourrait dire que les céramiques qui résistent à l'oxydation sont différentes des céramiques réfractaires.

Par céramique qui résiste à l'oxydation « différente » de la céramique réfractaire, on entend généralement que la céramique qui résiste à l'oxydation est d'une nature chimique différente de la céramique réfractaire.

Précisons que les couches éventuellement déposées lors de l'étape g) sont des couches bidimensionnelles.

Précisons que le procédé de dépôt chimique en phase vapeur CVD n'est pas fondamentalement différent du procédé d'infiltration chimique en phase vapeur CVI.

Le procédé de CVD se différencie cependant du procédé d'infiltration chimique en phase vapeur CVI par le fait que la pression mise en oeuvre dans un procédé de CVD, est de manière générale plus élevée que la pression mise en oeuvre dans un procédé de CVI.

Ainsi, dans le cas d'un procédé de CVI, la pression mise en oeuvre est-elle généralement de 0,1 kPa à 5 kPa, tandis qu'elle est généralement de plus de 5 kPa et jusqu'à la pression atmosphérique dans le cas d'un procédé de CVD.

Avantageusement, lesdites particules de la première couche, comprennent 100% de fibres courtes. En d'autres termes, lesdites particules sont toutes des fibres courtes.

Avantageusement, les fibres courtes comprennent une proportion majoritaire de fibres courtes qui sont sensiblement perpendiculaires, ou perpendiculaires, à la surface, de préférence toutes les fibres courtes, c'est-à-dire 100% des fibres courtes, sont sensiblement perpendiculaires, ou perpendiculaires, à la surface.

Par « sensiblement perpendiculaire », on entend que l'angle entre les fibres et la surface est de 90° plus ou moins 5°.

Avantageusement, le matériau susceptible d'être oxydé est choisi parmi les matériaux à base de carbone tels que les matériaux composites carbone/carbone ; les céramiques telles que les céramiques borures comme HfB₂, les céramiques carbures à l'exception de SiC comme TiC, ZrC, et HfC, les céramiques nitrures comme TiN et ZrN ; les céramiques composites telles que les céramiques composites SiC/SiC; les métaux ultraréfractaires tels que W ou Ta ; et les composites carbone /céramique tels que les composites C/SiC.

Généralement, le matériau susceptible d'être oxydé est bien entendu différent de la céramique qui résiste à l'oxydation constituant les particules de la première couche (étape b)).

Avantageusement, le catalyseur permettant la croissance de fibres courtes est choisi parmi les particules de diamant; les particules d'au moins un métal, telles que les particules de Cu, Cr, Fe, Ni, et Al, et les particules de leurs mélanges et alliages.

Avantageusement, les fibres courtes ont une longueur de 1 nm à 200 µm et un diamètre de 50 nm à 1 µm.

Avantageusement, la deuxième couche a une épaisseur de 1 nm à 10 µm, de préférence de 100 nm à 5 µm, de préférence encore de 2 à 3 µm.

Avantageusement, la troisième couche a une épaisseur de 1 nm à 10 µm, de préférence de 100 nm à 5 µm, de préférence encore de 2 à 3 µm.

Avantageusement, la quatrième couche a une épaisseur de 1 nm à 10 µm, de préférence de 100 nm à 5 µm, de préférence encore de 2 à 3 µm.

Avantageusement, la cinquième couche a une épaisseur de 1 nm à 10 µm, de préférence de 100 nm à 5 µm, de préférence encore de 2 à 3 µm.

De préférence toutes les couches à partir de la deuxième couche ont la même épaisseur.

Comme on l'a déjà indiqué, la céramique qui résiste à l'oxydation est différente de la céramique réfractaire.

Avantageusement, la céramique réfractaire est choisie parmi les céramiques oxydes, les céramiques nitrures, les céramiques borures, les céramiques carbures; leurs mélanges (de préférence entre elles) ; et les céramiques composites de celles-ci (de préférence entre elles).

Avantageusement, la céramique qui résiste à l'oxydation est choisie parmi les céramiques carbures, les céramiques nitrures, les céramiques borures, les céramiques oxydes; leurs mélanges (de préférence entre elles) ; et les céramiques composites de celles-ci (de préférence entre elles) ; la céramique qui résiste à l'oxydation étant différente de la céramique réfractaire.

De préférence, la céramique réfractaire est choisie parmi les carbures de métaux à l'exception de SiC, tels que HfC, ZrC, TiC, TaC, et WC; les mélanges desdits carbures de métaux entre eux, et les mélanges d'un ou plusieurs desdits carbures de métaux avec SiC (avec généralement une proportion minoritaire en masse de SiC) ; les céramiques composites desdits carbures de métaux entre eux, et les céramiques composites d'un ou de plusieurs desdits carbures de métaux avec SiC (avec généralement une proportion minoritaire en masse de SiC).

De préférence, la céramique qui résiste à l'oxydation est choisie parmi SiC, TiN, ZrN, HfB₂, ZrB₂; leurs mélanges ; et les céramiques composites de celles-ci.

Dans une forme de réalisation particulièrement préférée, la céramique qui résiste à l'oxydation est le SiC, et la céramique réfractaire est le HfC.

Avantageusement, les particules de la première couche, la troisième couche, la cinquième couche, et les couches en une céramique qui résiste à l'oxydation éventuelles préparées lors de l'étape g) sont constituées par une même céramique, de préférence SiC ; et la deuxième couche, la quatrième couche et les couches en une céramique réfractaire éventuelles préparées lors de l'étape g) sont constituées par une même céramique, de préférence HfC.

Avantageusement, le revêtement réfractaire de protection contre l'oxydation a une épaisseur de 4 nm à 1000 µm, de préférence de 10 nm à 600 µm.

Avantageusement, les étapes b) à g), sont toutes réalisées en continu dans un même réacteur de dépôt chimique en phase vapeur CVD ou d'infiltration chimique en phase vapeur CVI.

Avantageusement, les étapes b) à g), sont toutes réalisées à une même pression de 0,5 kPa à 50 kPa, par exemple de 5kPa, et une même température de 500°C à 1500°C, par exemple de 1000°C.

Le procédé selon l'invention se distingue fondamentalement des procédés de préparation de revêtement de protection contre l'oxydation de l'art antérieur tels que ceux qui ont été mentionnés plus haut.

Le procédé selon l'invention présente une suite spécifique d'étapes spécifiques qui n'a jamais été décrite dans l'art antérieur.

Aucun des documents de l'art antérieur cités plus haut ne fait mention d'un procédé de préparation d'un revêtement multicouche pour la PAO dans lequel on dépose alternativement par une technique de dépôt chimique en phase vapeur des couches d'une céramique qui résiste à l'oxydation et des couches d'une céramique réfractaire, la première couche déposée étant une couche comprenant, de préférence constituée par, des fibres courtes en une céramique qui résiste à l'oxydation, les fibres courtes étant de préférence toutes sensiblement perpendiculaires à la surface.

C'est notamment cette étape b) du procédé selon l'invention, au cours de laquelle on dépose une « forêt » de fibres courtes, également appelées « whiskers » qui différencie fondamentalement le procédé selon l'invention des procédés de l'art antérieur.

Cette première couche est ensuite recouverte d'une deuxième couche en céramique réfractaire c) puis d'une troisième couche en une céramique qui résiste à l'oxydation d). On peut ensuite éventuellement déposer une quatrième couche en une céramique réfractaire e), puis une cinquième couche en une céramique qui résiste à l'oxydation f), puis éventuellement répéter les étapes e) et f) autant de fois que nécessaire pour obtenir l'épaisseur de PAO désirée.

Dans le procédé selon l'invention, mis à part l'étape a) de dépôt d'une couche de catalyseur, toutes les étapes b) à g) de dépôt des différentes couches du revêtement multicouche se font par une même technique de dépôt chimique en phase vapeur CVD/CVI, ce qui simplifie grandement le procédé selon l'invention.

Cette technique de dépôt apporte de nombreux avantages, notamment une faible contamination des couches, l'obtention de dépôts denses et de composition contrôlée, la possibilité de préparer un revêtement multicouche par exemple HfC : SiC à couches fines, par exemple d'une épaisseur de 1 nm à 10 µm, de préférence de 100 nm à 5 µm, de préférence encore de 2 à 3 µm.

Par « dépôts denses », on entend généralement que ces dépôts ont une densité de plus de 95%, de préférence de plus de 98%, voire même de 100% de la densité théorique du matériau : on parle alors de densification totale. Ces dépôts denses sont généralement sans porosités visibles au Microscope Electronique à Balayage (MEB).

En résumé, le procédé selon l'invention ne présente pas les inconvénients, défauts, limitations et désavantages des procédés de l'art antérieur et apporte une solution aux problèmes des procédés de l'art antérieur.

Notamment, le procédé selon l'invention par rapport aux principaux types de procédés de préparation de PAO mentionnés plus haut présente les avantages suivants :
- il est facile à mettre en oeuvre ;
- il permet l'obtention de dépôts denses tels que définis plus haut ;
- les dépôts obtenus possèdent une microstructure tridimensionnelle particulière, avec une première couche spécifique comprenant, de préférence constituée par, une forêt de fibres courtes ou whiskers d'une céramique qui résiste à l'oxydation.

Le revêtement de protection contre l'oxydation obtenu par ce procédé présente, une microstructure tridimensionnelle spécifique, alliant de manière synergique la tenue à l'oxydation à l'ultraréfractarité ; cette microstructure originale est due de manière inhérente au procédé qui a été utilisé pour la préparer et notamment à l'étape b) de ce procédé au cours de laquelle on réalise le dépôt d'une première couche spécifique comprenant, de préférence constituée par, une « forêt de fibres ».

Il n'est pas possible d'obtenir cette microstructure tridimensionnelle spécifique unique par un autre procédé que le procédé de l'invention.

En particulier, le procédé selon l'invention permet, de manière surprenante, d'obtenir la totalité de cette microstructure tridimensionnelle spécifique par un procédé de dépôt chimique en phase vapeur CVD alors que jusqu'à présent, et comme le montre le document [10], on pensait que le dépôt chimique en phase vapeur CVD ne pouvait produire qu'un empilement de couches en 2D.

Selon l'invention, on réalise ainsi l'alternance de couches non plus comme un simple empilement de couches en deux dimensions comme c'est le cas dans le document [10] mais en commençant par le dépôt, en tant que première couche, d'une couche spécifique comprenant, de préférence constituée par, une forêt de fibres courtes qui est ensuite recouverte d'une manière homogène et sans porosité par une deuxième couche en une céramique réfractaire puis par une troisième couche en une céramique qui résiste à l'oxydation éventuellement par des quatrième et cinquième couches, et éventuellement encore par une alternance de couches 2D.

Il est à noter que le revêtement devient bidimensionnel « 2D » à partir de la quatrième couche, ou à partir de l'alternance de couches qui suit la cinquième couche éventuelle.

Jusqu'à la troisième couche ou jusqu'à la cinquième couche, si cette dernière est présente, le revêtement possède une microstructure tridimensionnelle. On obtient ainsi, grâce au procédé de l'invention, un revêtement de PAO globalement à microstructure tridimensionnelle qui combine de manière synergique deux propriétés avantageuses, à savoir la réfractarité et la tenue à l'oxydation.

Il a été effectivement montré sur un substrat de C, ou de C/C, qu'un tel revêtement de PAO était dense (densité supérieure ou égale à 95%, voire supérieure ou égale à 98%, même égale à 100%) et non fissuré.

Lorsque le substrat est en un matériau tel qu'un matériau composite C/C, le procédé selon l'invention permet d'allier aux propriétés thermostructurales des composites une protection contre l'oxydation efficace à haute température, à savoir généralement supérieure à 1200°C et pouvant atteindre 2000°C, voire 2500°C pendant une durée prolongée, par exemple jusqu'à 10 minutes.

Le revêtement de PAO préparé par le procédé selon l'invention présente une résistance à l'oxydation bien supérieure aux revêtements de PAO de l'art antérieur et notamment aux revêtements de PAO bidimensionnels tels que ceux décrits dans le document [10]. Ainsi, il est montré dans les exemples qui suivent qu'un revêtement de PAO obtenu avec le procédé selon l'invention était efficace après un traitement d'oxydation sous air réalisé à une température pouvant aller jusqu'à 2000°C et pendant une longue durée de 205 secondes, alors que le revêtement de PAO bidimensionnel du document [10] n'était plus efficace à partir de 1800°C.

En conclusion, le procédé selon l'invention aboutit à un revêtement dont la microstructure est globalement tridimensionnelle, ce qui a pour effet d'améliorer l'accroche du revêtement sur le substrat et de plus, lors de l'oxydation, cette microstructure conduit à une synergie entre les céramiques réfractaires d'une part et les céramiques qui résistent à l'oxydation d'autre part, notamment lorsque ces céramiques sont des céramiques carbures, et en particulier lorsque la céramique réfractaire est le HfC et la céramique qui résiste à l'oxydation est SiC.

La réaction chimique entre O₂, et les deux céramiques, notamment les deux céramiques carbures, en particulier SiC et HfC conduit localement et simultanément à la formation de deux composés oxydes dans l'un desquels l'oxygène est à l'état d'oxydation 4 et qui est liquide en-dessous de 2000°C. Dans le cas où les deux céramiques sont le SiC et le HfC, ces deux composés sont le HfO₂ qui est solide à 200°C et très réfractaire et un autre oxyde, le HfSiO₄ qui est liquide à 2000°C et qui vient combler les porosités de HfO₂.

Dans le cas de couches seulement bidimensionnelles. (document [10]), la réaction est seulement successive et donc moins « intime » qu'avec la microstructure tridimensionnelle obtenue selon l'invention.

L'invention concerne en outre un revêtement réfractaire multicouche de protection contre l'oxydation comprenant la succession de couches suivantes :
- une première couche constituée par des particules d'une céramique qui résiste à l'oxydation, lesdites particules comprenant une majorité de fibres courtes en une céramique qui résiste à l'oxydation ;
- une deuxième couche en une céramique réfractaire qui revêt la première couche de manière totalement homogène, fibre à fibre et sans laisser de porosité;
- une troisième couche en une céramique qui résiste à l'oxydation ;
- éventuellement, une quatrième couche en une céramique réfractaire ;
- éventuellement une cinquième couche en une céramique qui résiste à l'oxydation ;
- éventuellement une succession, répétée de 1 à 100 fois, de préférence de 1 à 50 fois, d'une couche en une céramique réfractaire et d'une couche en une céramique qui résiste à l'oxydation ;
ledit revêtement présentant une microstructure tridimensionnelle jusqu'à la troisième couche ou jusqu'à la cinquième couche éventuelle ; la céramique qui résiste à l'oxydation étant différente de la céramique réfractaire.

Plus exactement, on pourrait dire que les céramiques qui résistent à l'oxydation sont différentes des céramiques réfractaires.

Ce revêtement est intrinsèquement nouveau et présente des propriétés avantageuses qui ont déjà été largement exposées plus haut.

L'invention a enfin trait à une pièce en au moins un matériau susceptible d'être oxydé, revêtue sur au moins une de ses surfaces par ledit revêtement réfractaire multicouche de protection contre l'oxydation.

D'autres caractéristiques et avantages de l'invention ressortiront mieux à la lecture de la description qui va suivre.

Dans cette description détaillée, on complète notamment la description qui a été faite plus haut du procédé selon l'invention, on décrit l'installation utilisée pour mettre en oeuvre le procédé selon l'invention et des exemples de réalisation de revêtements de PAO par le procédé selon l'invention ainsi que d'un revêtement comparatif.

Cette description est bien donnée à titre illustratif et non limitatif en référence aux Figures annexées dans lesquelles :

### BRÈVE DESCRIPTION DES DESSINS

- La Figure 1 est une vue schématique d'une installation pour la mise en oeuvre du procédé selon l'invention.
- La Figure 2 est une vue schématique en coupe verticale de l'appareil de chloruration qui permet de produire le composé HfClₓ précurseur du HfC.
- La Figure 3 est une vue schématique en coupe verticale d'un four de dépôt chimique en phase vapeur CVD mis en oeuvre pour le dépôt des couches de céramique dans le procédé de l'invention.
- La Figure 4 présente des clichés pris au Microscope Electronique à Balayage (MEB) à un grossissement de 800 (A), ou à un grossissement de 5000 (B), des cinq premières couches déposées sur une surface d'un substrat en composite carbone/carbone C/C dans l'Exemple 1, (échantillon 1).
   L'échelle représentée sur la Figure 4A est de 100 µm, et l'échelle représentée sur la Figure 4B est de 10 µm.
- La Figure 5 présente des clichés pris au Microscope Electronique à Balayage (MEB) à des grossissements de 3000 (A) et 6000 (B et C) du revêtement de PAO déposé dans l'exemple 2 (échantillon 2) conformément à l'invention. La Figure 5A montre la microstructure du revêtement après le dépôt successif de cinq couches de carbure. La Figure 5B est une vue partielle de la Figure 5A qui montre la croissance de fibres de SIC. La Figure 5C est une vue partielle de la Figure 5A qui montre l'alternance des 5 couches successivement déposées.
   L'échelle représentée sur la Figure 5A est de 20 µm.
- La Figure 6 présente un cliché pris au Microscope Electronique à Balayage (MEB) à un grossissement de 2400 du revêtement de PAO déposé dans l'exemple 3 (échantillon 3) conformément à l'invention et constitué de 10 couches SiC/HfC alternées.
   L'échelle représentée sur la Figure 6 est de 30 µm.
- La Figure 7 est un graphique qui montre les profils de température (en °C) et de flux (en MW/m²) utilisés lors des expériences d'oxydation à haute température réalisés à l'aide d'un four à images d'arc, sur les échantillons 1 et 3 préparés plus haut.
- La Figure 8 est une photographie de l'état de surface de l'échantillon 1 qui est un échantillon décacouches de type 2D après un traitement d'oxydation à haute température (1800°C), d'une durée de 160 secondes ;
- La Figure 9 est une photographie de l'état de surface de l'échantillon 3 qui est un échantillon décacouches de type 3D après un traitement d'oxydation à haute température (2000°C), d'une durée de 205 secondes.

### EXPOSÉ DÉTAILLÉ DE MODES DE RÉALISATION PARTICULIERS

Le procédé selon l'invention est un procédé pour préparer un revêtement multicouche de protection contre l'oxydation sur au moins une surface d'au moins une pièce en au moins un matériau susceptible d'être oxydé qui comprend les étapes successives a) à h) mentionnées plus haut.

Au cours de l'étape a) du procédé selon l'invention, on dépose sur ladite surface de la pièce une couche d'un catalyseur permettant la croissance de fibres courtes en une céramique qui résiste à l'oxydation.

Selon l'invention, la pièce à revêtir est généralement en un matériau susceptible d'être oxydé.

Par matériau « susceptible d'être oxydé » ou « matériau sensible à l'oxydation », on entend généralement, au sens de l'invention un matériau dont la perte ou le gain de masse est significatif après un traitement thermique en présence d'oxygène par opposition à un matériau, tel qu'une céramique, qui résiste à l'oxydation tel qu'il sera défini plus bas notamment en relation avec le concept de formation d'une couche passivante.

Le matériau susceptible d'être oxydé est généralement choisi parmi les matériaux à base de carbone tels que les matériaux composites carbone/carbone ; les céramiques telles que les céramiques borures comme HfB₂, les céramiques carbures à l'exception du SiC comme, TiC, ZrC, et HfC, les céramiques nitrures comme TiN et ZrN ; les céramiques composites telles que les composites SiC/SiC ; les métaux ultraréfractaires tels que W ou Ta ; et les composites carbone/céramique tels que les composites C/SiC.

Par « matériau à base de carbone », on entend généralement un matériau qui comprend plus de 50%, de préférence plus de 80%, de préférence encore plus de 90% en masse de carbone, mieux 100% en masse de carbone.

La pièce à revêtir peut avoir une forme et une taille quelconques, à la condition toutefois qu'elle puisse être disposée dans un réacteur de dépôt chimique en phase vapeur CVD.

Généralement, le matériau susceptible d'être oxydé est bien entendu différent de la céramique qui résiste à l'oxydation constituant les particules de la première couche (étape b)).

Le catalyseur favorisant la croissance de fibres courtes se présente généralement sous la forme de particules choisies parmi les particules de diamant et les particules d'au moins un métal choisi de préférence parmi Cu, Cr, Fe, Ni, Al et leurs mélanges et alliages.

Le dépôt de la couche de catalyseur peut être réalisé par exemple en immergeant, trempant la surface dans un bain d'une suspension (barbotine) contenant les particules de catalyseur.

Par exemple, on pourra tremper la surface pendant une durée par exemple de 15 minutes dans une barbotine aqueuse de particules fines (c'est-à-dire dont la plus grande dimension telle que le diamètre est généralement de 10 nm à 3 µm) d'un métal choisi par exemple parmi Ni, Fe, Al, Cr Cu, et leurs mélanges et alliages.

Il est également possible d'utiliser une solution d'au moins un sel de métal par exemple un sel d'un des métaux cités plus haut tel que le nitrate de nickel, ou le nitrate d'aluminium, par exemple à une concentration 2 10⁻² mol/L et de tremper la surface dans cette solution par exemple pendant une durée de 15 minutes. On fait ensuite subir un traitement thermique à la surface pour transformer le sel déposé en particules métalliques catalytiques. La couche de particules de catalyseur a généralement une épaisseur de 1 nm à 5 µm, de préférence de 20 nm à 3 µm.

La couche de particules de catalyseur peut être continue ou discontinue avec des particules de catalyseurs déposées de manière discrète sur la surface.

On fait ensuite croître, sur la surface revêtue de la couche de catalyseur, par un procédé de dépôt chimique en phase vapeur CVD ou un procédé d'infiltration chimique en phase vapeur CVI, une première couche constituée par des particules d'une céramique qui résiste à l'oxydation, lesdites particules comprenant une majorité de fibres courtes en une céramique qui résiste à l'oxydation.

Comme on l'a déjà indiqué plus haut, lesdites particules comprennent de préférence 100% de fibres courtes.

De préférence, en outre, les fibres courtes comprennent une proportion majoritaire de fibres courtes qui sont sensiblement perpendiculaires à la surface, de préférence toutes les fibres courtes sont sensiblement perpendiculaires à la surface.

Pour simplifier dans ce qui suit, on appelle la première couche « couche de fibres » courtes même si cette première couche n'est pas toujours exclusivement constituée par des fibres courtes.

Les fibres courtes sont en une céramique qui résiste à l'oxydation, en d'autres termes en une céramique qui présente une bonne tenue à l'oxydation.

Par « céramique qui résiste à l'oxydation », on entend généralement une céramique qui présente une faible perte ou prise de masse en présence d'une pression partielle d'oxygène et en température.

Cette faible perte ou prise de masse en présence d'une pression partielle d'oxygène et en température change selon les céramiques et peut être déterminée par l'homme du métier.

Par exemple HfC seul, sous oxydation, se transforme rapidement dès 400°C en HfO₂ qui est poreux avec un gain de masse.

En revanche, SiC se passive en formant à sa surface une couche de SiO₂ liquide (verre) qui est une barrière à la diffusion de l'oxygène, et SiC est donc protégé par sa couche de SiO₂.

Dans le cas de SiC qui résiste bien à l'oxydation, il y aura donc une variation de masse mais très faible par rapport à celui de HfC.

Une définition plus précise pourrait donc être la suivante : une céramique oxyde ou bien une céramique carbure, nitrure, ou borure qui résiste bien à l'oxydation est une céramique qui, traitée sous air à des températures comprises entre 400°C et la température de fusion ou de décomposition de cette céramique présente à sa surface une couche passivant d'oxyde associé (par exemple SiO₂ pour SiC) qui empêche ou ralentit toute diffusion de l'oxygène vers la céramique.

La céramique qui résiste à l'oxydation est généralement choisie parmi les céramiques carbures, les céramiques nitrures, les céramiques borures, les céramiques oxydes, (on peut imaginer revêtir HfC par SiO₂ par exemple) ; leurs mélanges (de préférence entre elles), et les céramiques composites de celles-ci (de préférence entre elles) ; la céramique qui résiste à l'oxydation étant différente de la céramique réfractaire.

Parmi les céramiques carbures, on peut citer par exemple SiC, ZrC, HfC, et le TaC; parmi les céramiques nitrures, on peut citer le TiN, et le ZrN; parmi les céramiques borures, on peut citer le HfB₂ et le ZrB₂.

Il est en outre avantageux de choisir en tant que céramique qui résiste à l'oxydation une céramique qui présente un équilibre thermodynamique avec la céramique réfractaire qui constitue la deuxième couche quelle que soit la température.

L'homme du métier, en faisant éventuellement appel aux données disponibles dans la littérature saura facilement déterminer pour une céramique qui résiste à l'oxydation donnée, les céramiques réfractaires qui remplissent ces conditions d'équilibre thermodynamique, et vice et versa.

Les fibres courtes de la première couche sont de préférence en SiC.

Selon l'invention, les fibres courtes de la première couche et de préférence toutes les fibres courtes de la première couche sont disposées de manière sensiblement perpendiculaire, et de préférence de manière perpendiculaire, à la surface et on peut ainsi comparer cette première couche à une « forêt » de fibres courtes, dans laquelle les fibres seraient comme des troncs d'arbres.

Ces fibres courtes ont généralement une longueur de 1 nm à 200 µm

Ces fibres courtes ont généralement une section circulaire ou sensiblement circulaire avec un diamètre par exemple de 50 nm à 1 µm.

Selon l'invention, la croissance de la première couche de fibres courtes sur la surface de la couche de catalyseur, est réalisée par un procédé de dépôt chimique en phase vapeur CVD ou un procédé d'infiltration chimique en phase vapeur CVI.

Un tel procédé de dépôt chimique en phase vapeur est bien connu de l'homme du métier.

Il consiste à mettre en contact la surface de la couche de catalyseur avec des gaz réactifs qui réagissent avec les particules de catalyseur pour former les fibres courtes.

Les gaz réactifs comprennent généralement un gaz d'au moins un composé précurseur de la céramique qui résiste à l'oxydation, et éventuellement au moins un gaz réducteur.

Le(s) composé(s) précurseur et le gaz réducteur peuvent être facilement choisis par l'homme du métier en fonction de la céramique qui résiste à l'oxydation qui constitue les fibres.

Ainsi, dans le cas où la céramique qui résiste à l'oxydation est le SiC, les gaz réactifs comprennent un gaz d'un composé précurseur choisi généralement parmi les silanes tels que le méthyltrichlorosilane (MTS), et au moins un gaz réducteur qui est généralement de l'hydrogène.

L'hydrogène intervient dans le dépôt chimique en phase vapeur du SiC en réduisant successivement le précurseur.

Les gaz réactifs sont généralement acheminés sur la surface sous la forme d'un mélange avec un gaz vecteur neutre ou inerte choisi généralement parmi les gaz rares comme l'argon, l'azote, et leurs mélanges.

La croissance de la première couche de fibres courtes est généralement réalisée, dans un réacteur ou four de CVD, dans les conditions suivantes :
- Pression dans le réacteur : 0,5 à 50 kPa, de préférence 5 kPa ;
- Température : 700°C à 1500°C, de préférence 1000°C ;
- Débits :
   - Débit de gaz de composé(s) précurseur(s) : 0,02 à 1 L/min ;
   - Débit de gaz réducteur(s) : 0,2 à 2 L/min ;
   - Débit de gaz vecteur : 0 à 2 L/min.
   - Rapport Débit de gaz réducteur(s)/ Débit de gaz de composé(s) précurseur(s) de 1 à 10.

Les débits de gaz et le rapport de débits mentionné plus haut varient selon le(s) gaz réducteur(s) et le(s) composé(s) précurseur(s).

Ainsi, dans le cas du dépôt d'une couche de fibres courtes en SiC, le rapport du Débit de gaz réducteur(s)/ Débit de gaz de composé(s) précurseur(s) par exemple Débit d'hydrogène/Débit de méthyltrichlorosilane est 4.
- Durée de dépôt de cette couche : 10 min à 5 heures, de préférence 2 heures.

On revêt ensuite la première couche de fibres courtes en une céramique qui résiste à l'oxydation, par un procédé de dépôt chimique en phase vapeur CVD ou un procédé d'infiltration chimique en phase vapeur CVI, de manière totalement homogène, fibre à fibre et sans laisser de porosité par une deuxième couche en une céramique réfractaire.

La céramique réfractaire de la deuxième couche est différente de la céramique qui résiste à l'oxydation de la première couche de fibres courtes.

Par « céramique réfractaire », on entend généralement une céramique qui possède une température de frittage supérieure à 1300°C.

La céramique réfractaire peut être choisie parmi les céramiques oxydes, les céramiques nitrures, les céramiques borures, les céramiques carbures ; leurs mélanges (de préférence entre elles), et les céramiques composites de celles-ci (de préférence entre elles).

Avantageusement, la céramique réfractaire est choisie parmi les carbures de métaux à l'exception de SiC tels que HfC, ZrC, TiC, TaC, WC ; les mélanges desdits carbures de métaux entre eux, et les mélanges d'un ou de plusieurs desdits carbures de métaux avec SiC (avec généralement une proportion minoritaire en masse de SiC) ; les céramiques composites desdits carbures de métaux entre eux, et les céramiques composites d'un ou de plusieurs desdits carbures de métaux avec SiC (avec généralement une proportion minoritaire en masse de SiC).

La céramique réfractaire peut même être une céramique qualifiée de céramique « ultraréfractaire ».

Une telle céramique ultraréfractaire présente généralement une température de frittage supérieure à 1300°C.

Un exemple d'une telle céramique ultraréfractaire est le HfC.

A titre d'exemple, la deuxième couche peut être une couche d'une céramique ultraréfractaire, par exemple de HfC, ZrC, TaC, qui revêt une première couche de SiC qui présente un bonne tenue à l'oxydation et un équilibre thermodynamique avec HfC quelle que soit la température, par exemple entre 500°C et 2850°C.

La deuxième couche en une céramique réfractaire a généralement une épaisseur de 1 nm à 10 µm, par exemple de 2 microns.

Le dépôt de la deuxième couche en une céramique réfractaire est généralement réalisé dans un réacteur ou four de CVD/CVI, de la même manière que le dépôt de la première couche en choisissant bien entendu les gaz réactifs adéquats permettant le dépôt d'une couche de la céramique réfractaire voulue.

Ainsi, dans le cas où la céramique réfractaire est le HfC, les gaz réactifs comprennent un gaz d'un composé précurseur choisi généralement parmi HfClₓ où x est un nombre entier de 1 à 4 (HfClₓ représente un mélange de chlorures dans lequel le chlorure HFCl₄ est généralement majoritaire), du méthane, et au moins un gaz réducteur qui est généralement de l'hydrogène. L'approvisionnement en HFCl₄ est effectué à l'aide d'un four de chloruration « ex-situ ».

Les conditions de ce dépôt sont analogues à celles mentionnées pour la première couche notamment en ce qui concerne la température, la pression et la durée de l'opération de dépôt.

Comme on l'a indiqué plus haut, les débits de gaz et le rapport de débits mentionnés plus haut varient selon le(s) gaz réducteur(s) et le(s) composé(s) précurseur(s).

Ainsi, dans le cas du dépôt d'une couche céramique réfractaire qui est du HfC, le rapport du Débit de gaz réducteur(s)/ Débit de gaz de composé(s) précurseur(s) par exemple Débit d'hydrogène/Débit de HfClₓ est de 8,5.

Dans les bonnes conditions de température et de pression telles que définies plus haut, il est possible de réaliser une infiltration de la céramique réfractaire de la deuxième couche.

Lors du dépôt de la deuxième couche, le précurseur (les précurseurs) n'est pas un liquide mais un gaz (du fait du principe même des procédés de CVD ou de CVI). Le précurseur gazeux peut pénétrer absolument dans toutes les porosités de la première couche de fibres courtes ce qui donne un matériau dense tel que défini plus haut, par exemple un matériau avec une densité de 100% (densification totale c'est-à-dire égale à 100% de la densité théorique du matériau), sans étape de post-traitement thermique (voir figures).

On revêt ensuite la deuxième couche, par un procédé de dépôt chimique en phase vapeur CVD ou un procédé CVI, par une troisième couche en une céramique qui résiste à l'oxydation. Cette céramique qui résiste à l'oxydation est choisie parmi les céramiques qui résistent à l'oxydation déjà mentionnées plus haut.

La céramique qui résiste à l'oxydation de la troisième couche est bien entendu différente de la céramique réfractaire de la deuxième couche.

De préférence, la céramique qui résiste à l'oxydation de la troisième couche est la même céramique qui résiste à l'oxydation que celle de la première couche de fibres courtes, par exemple cette céramique est le SiC. Ou bien la céramique qui résiste à l'oxydation de la troisième couche peut être différente de la céramique qui résiste à l'oxydation de la première couche.

Le dépôt de la troisième couche en une céramique qui résiste à l'oxydation est généralement réalisé dans un réacteur ou four de CVD/CVI, de la même manière que le dépôt de la première couche, et le dépôt de la deuxième couche en choisissant bien entendu les gaz réactifs adéquats permettant le dépôt d'une couche de la céramique voulue.

Ainsi, comme on l'a déjà vu plus haut, dans le cas où la céramique qui résiste à l'oxydation est le SiC, les gaz réactifs comprennent un gaz d'un composé précurseur choisi généralement parmi les silanes tels que le méthyltrichorosilane (MTS), et au moins un gaz réducteur qui est généralement de l'hydrogène.

Les conditions de ce dépôt de la troisième couche sont analogues à celles mentionnées pour la première couche notamment en ce qui concerne la température, la pression et la durée de l'opération de dépôt, et les débits.

La troisième couche a généralement une épaisseur de 1 nm à 10 µm.

Eventuellement, on revêt la troisième couche, par un procédé de dépôt chimique en phase vapeur CVD ou un procédé CVI, par une quatrième couche en une céramique réfractaire qui est généralement la même céramique que la céramique réfractaire de la deuxième couche, par exemple le HfC. Ou bien la céramique réfractaire de la quatrième couche est différente de la céramique réfractaire de la deuxième couche.

La céramique réfractaire de la quatrième couche est bien entendu différente de la céramique qui résiste à l'oxydation de la troisième couche.

Le dépôt de la quatrième couche est réalisé exactement de la même manière que le dépôt de la deuxième couche.

La quatrième couche a généralement une épaisseur de 1 nm à 10 µm.

Enfin, dans une dernière étape, on dépose éventuellement par un procédé de dépôt chimique en phase vapeur CVD ou un procédé CVI, une cinquième couche en une céramique qui résiste à l'oxydation qui est de préférence identique à la céramique de la troisième couche et de la première couche telle que SiC.

Mais la céramique qui résiste à l'oxydation de la cinquième couche peut être différente de la céramique de la troisième couche et/ou de la première couche.

La céramique qui résiste à l'oxydation de la cinquième couche est bien entendu différente de la céramique réfractaire de la quatrième couche.

Le dépôt de cette cinquième couche en une céramique qui résiste à l'oxydation est réalisé exactement de la même manière que le dépôt des première et troisième couches.

Cette cinquième couche a généralement une épaisseur de 1 nm à 10 µm.

On récupère à l'issue du dépôt de la dernière couche la pièce, revêtue sur au moins une de ses surfaces par un revêtement réfractaire de protection contre l'oxydation (PAO), à microstructure tridimensionnelle.

La PAO ainsi obtenue présente une alternance d'au moins trois couches (dans le cas où l'on ne procède pas au dépôt des quatrième et cinquième couches) de céramiques ayant une bonne tenue à l'oxydation (type SiC) et de céramique réfractaire (type HfC).

La microstructure ainsi obtenue, à cause du dépôt de fibres courtes et notamment d'une forêt de fibres courtes dans la première étape, présente une microstructure que l'on peut qualifier de microstructure tridimensionnelle alternée.

De préférence, toutes les étapes de dépôt de couches par CVD ou CVI, c'est-à-dire les étapes de dépôt par CVD ou CVI des première, deuxième et troisième couches, de la quatrième et de la cinquième couches éventuelles sont toutes réalisées en continu dans un même réacteur de dépôt chimique en phase vapeur CVD ou d'infiltration chimique en phase vapeur CVI en changeant seulement un nombre limité de paramètres entre les étapes.

En d'autres termes, le dépôt de ces couches peut être réalisé en une seule étape et en continu en changeant un minimum de paramètres entre les dépôts de couches.

Généralement, la pression, la température et la durée de chacune des étapes de dépôt de couche sont identiques et seuls changent la nature des gaz de composés précurseurs et des gaz réducteurs et le débit de ces gaz.

Il est possible sur la PAO tridimensionnelle obtenue à l'issue du dépôt de la cinquième couche de continuer à empiler des couches bidimensionnelles, à l'instar de ce qui est décrit dans le brevet [10] à la description duquel on pourra se référer.

Ainsi, on pourra déposer sur la cinquième couche, une alternance de couches en une céramique réfractaire analogues à la deuxième ou quatrième couche, et de couches en une céramique qui résiste à l'oxydation analogues à la troisième couche.

Pour déposer cette alternance de couches, les étapes successives de dépôt de la deuxième puis de la troisième couche peuvent être répétées de 1 à 100 fois, de préférence de 1 à 50 fois.

Par exemple sur une PAO tridimensionnelle de 5 couches, on peut encore déposer 10 couches bidimensionnelles.

De préférence, toutes les céramiques qui résistent à l'oxydation qui sont déposées lors de ces étapes sont identiques à la céramique de la troisième couche et de la première couche telle que le SiC, et toutes les céramiques réfractaires qui sont déposées lors de ces étapes sont identiques à la céramique réfractaire de la quatrième couche et de la deuxième couche, telle que le HfC.

Dans ce qui suit, on donne une description de l'installation utilisée pour mettre en oeuvre le procédé selon l'invention, plus précisément on décrit l'installation dite installation de CVD ou de CVI qui est utilisée pour réaliser le dépôt sur le substrat de la première couche de fibres courtes et des couches suivantes de céramique réfractaire ou de céramique résistant à l'oxydation (étapes b) à g) du procédé selon l'invention).

L'étape a) du procédé selon l'invention, au cours de laquelle on dépose sur la surface du substrat une couche d'un catalyseur permettant la croissance de fibres courtes en une céramique qui résiste à l'oxydation est réalisée préalablement dans une installation séparée et le substrat dont une surface au moins a ainsi été revêtue d'une couche de catalyseur est ensuite traité lors des étapes b) à g) dans l'installation de CVD ou de CVI qui est décrite ci-après.

L'installation qui est décrite dans ce qui suit est plus particulièrement une installation qui permet le dépôt d'un revêtement comprenant des couches alternées de SiC et de HfC mais une telle installation pourrait également été utilisée pour le dépôt de revêtements comprenant des couches de céramiques autres que le SiC et le HfC moyennant quelques adaptations éventuelles à la portée de l'homme du métier dans ce domaine de la technique.

En outre, les gaz réactifs et précurseurs mentionnés dans la description qui suit sont les gaz réactifs et précurseurs utilisés pour la préparation de couches de SiC et de HfC, mais ces gaz réactifs et précurseurs ne sont donnés qu'à titre d'exemples et l'homme du métier pourra facilement choisir la nature des gaz réactifs, et précurseurs afin de préparer des couches en d'autres céramiques.

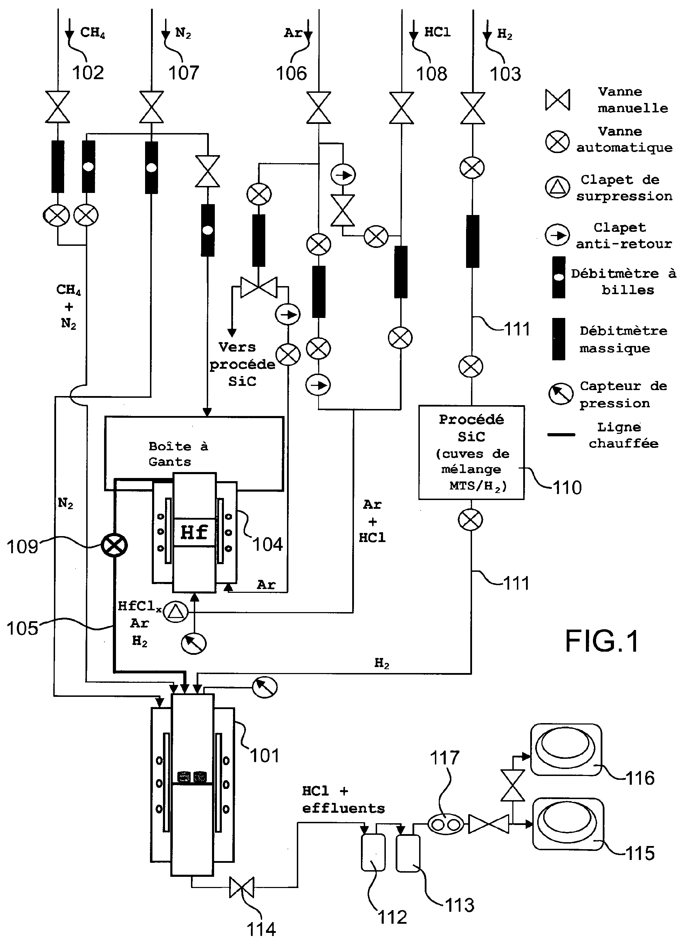

La Figure 1 présente une vue globale de l'ensemble de l'installation. Celle-ci peut être décomposée en trois parties, un système d'alimentation en gaz précurseurs, en gaz vecteur, et en gaz réducteur; le four de dépôt par CVD/CVI ; et enfin un système de traitement des effluents et des produits gazeux qui n'ont pas réagi.
- Système d'alimentation en gaz précurseurs, en gaz vecteur, et en gaz réducteur.

Les gaz précurseurs et le gaz réducteur sont, soit directement acheminés au sommet du four de CVD/CVI (101) par un système de flexibles : c'est le cas du méthane (102), du gaz réducteur hydrogène (103), et du méthyltrichlorosilane (MTS) précurseur du SiC ; soit produits dans un dispositif *ex situ* de chloruration (104) puis acheminés vers le four de CVD par l'intermédiaire d'une canalisation (105) : c'est le cas du HfClₓ précurseur du HfC.

Sur la figure 1 sont également représentés les circuits d'alimentation en gaz vecteur argon (106) ou azote (107), et en HCl (108) qui alimentent le dispositif de chloruration (104).
- Dispositif de chloruration.

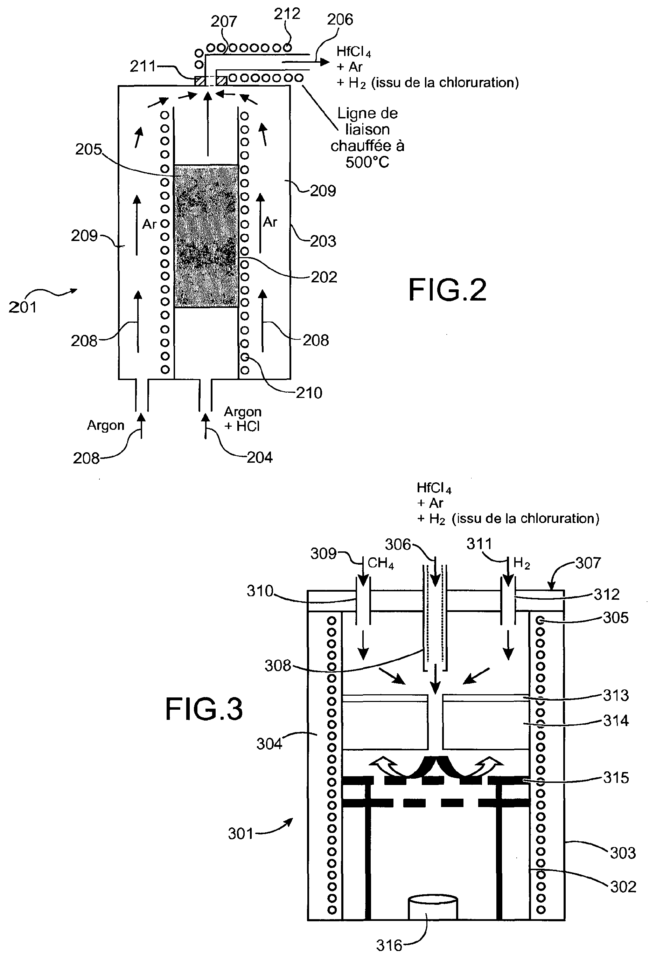

Le dispositif de chloruration ou four de chloruration encore appelé chlorurateur, qui permet de produire le composé HfClₓ précurseur du HfC, est représenté sur la Figure 2.

Ce dispositif de chloruration est relié au four de dépôt par CVD/CVI.

Il s'agit d'un four résistif cylindrique (201) d'un diamètre de 300 mm et d'une hauteur de 700 mm, à double enveloppe interne (202) et externe (203) et à parois chaudes dont l'intérieur est en graphite.

La chloruration se fait en injectant un mélange de HCl et d'argon (flèche 204) utilisé comme gaz vecteur, dans un lit d'hafnium métallique (205) placé à l'intérieur du dispositif (201).

Ce mélange (204) réagit avec le lit d'hafnium métallique (205) pour former des chlorures métalliques HfClₓ et de l'hydrogène.

Le mélange de HfClₓ et d'hydrogène est ensuite acheminé dans un courant de gaz vecteur (flèche 206) vers le four de dépôt par CVD, par l'intermédiaire d'une canalisation chauffée (207).

De l'argon (flèches 208) est également injecté dans l'espace (209) défini entre les deux enveloppes externe (203) et interne (202) du dispositif de chloruration pour inerter le dispositif et pour éviter que du HCl ou des chlorures métalliques pénètrent dans cet espace (209).

L'enveloppe externe (203) est également refroidie par un circuit de fluide réfrigérant tel que de l'eau.

La température maximale de chauffe dans le four de chloruration est de 800°C. Elle est fournie par des cordons chauffants (210) qui entourent l'enveloppe interne (202).

Afin de ne pas favoriser la condensation des chlorures notamment à l'intérieur ou en sortie du four, la température minimale dans toute l'installation lors de la mise en oeuvre du procédé devra être supérieure à la température de condensation des chlorures.

Le chlorure HfCl₄, majoritaire, condense à 320°C environ à la pression atmosphérique et à 230°C sous pression réduite. Afin de s'assurer une marge de sécurité et dans le souci d'éviter des phénomènes de bouchage en sortie de procédé, la température minimale a été fixée à 400°C. Ainsi, la sortie du chlorurateur, premier point froid en sortie de four, est chauffée par un collier chauffant résistif (211) à 400°C et une température de 500°C est appliquée à la canalisation chauffée (207, 105) reliant le chlorurateur (201, 104) au four de CVD (101).

Cette canalisation chauffée (207, 105) peut être constituée d'un flexible en inox autour duquel vient s'enrouler un cordon chauffant (212) d'environ 3 mètres et d'une température maximale de chauffe de 900°C.

Toutefois, cette canalisation comporte plusieurs points froids, sièges possibles de phénomènes de condensation.

Outre l'architecture coudée de la ligne, une vanne haute température (109) isolant le chlorurateur 104, 201) du four de CVD (101) a été mise en place pour isoler le chlorurateur lors du dépôt de SiC pour des raisons de sécurité qui constitue un point froid important. Un cordon chauffant (400°C) a été enroulé autour de cette vanne (109).

La charge métallique utilisée (205) est de l'hafnium de grade électrolytique. Un tel hafnium est disponible par exemple auprès de la société CEZUS^{®} sous la référence SAQM 1032.

Cette charge (205) est placée dans une cartouche en graphite interchangeable usinée de part et d'autre de manière à laisser pénétrer les gaz.

Le seuil en impuretés (zirconium exclu) contenu dans la charge et annoncé par le fournisseur est inférieur à 0,4% et le taux d'oxygène, source majeure de contamination, est de l'ordre de 500 ppm.

La granulométrie des particules étant disparate et comprise généralement entre 0,85 et 55 mm, une sélection de la fraction granulométrique la plus élevée à savoir de 5 mm à 55 mm a été nécessaire.
- Système d'alimentation en précurseur du SiC.

Parallèlement à l'appareillage permettant le dépôt d'HfC, un dispositif permettant un dépôt de SiC dans le même four de dépôt (101) est inclus dans l'optique d'un dépôt en alternance de couches de HfC et de SiC par CVD.

Pour ce faire, une étuve (110) contenant le précurseur du dépôt de SiC tel que du méthyltrichlorosilane (MTS), est prévue qui contient deux cuves de mélange H_{2/} précurseur (MTS), l'hydrogène intervenant dans la CVD du SiC en réduisant successivement le précurseur.

Ce dispositif (110) est maintenu en permanence à 50°C dans le cas où le précurseur est du MTS, afin de maintenir le MTS sous forme gazeuse (le MTS est en effet liquide à la température ambiante). Notons que la canalisation d'H₂ (111) est commune aux deux procédés de dépôt HfC et SiC.
- Four de dépôt par CVD/CVI.

Le dépôt d'HfC par dépôt chimique en phase vapeur CVD ou infiltration chimique en phase vapeur CVI se fait dans un four (301) à parois chaudes à double enveloppe interne (302) et externe (303) d'une hauteur totale de 180 cm (voir Figure 3).

La zone réactionnelle est délimitée par un tube en silice de diamètre 120 mm, formant l'enveloppe interne (302), au sein duquel circulent les gaz réactifs.

De l'azote est injecté dans l'espace (304) défini entre les deux enveloppes externe (303) et interne (302) afin de réaliser un balayage par un flux d'azote dans cet espace (304), et inerter le dispositif

L'enveloppe externe (303) est également refroidie par un circuit de fluide réfrigérant tel que de l'eau.

De plus, un système inductif avec des spires (305), des isolants et un suscepteur est situé dans l'espace (304) entre l'enveloppe interne (302) et l'enveloppe externe (303).

La Figure 3 schématise le dispositif de dépôt CVD et détaille l'arrivée et la circulation des gaz au sein du réacteur.

L'acheminement des produits de la réaction de chloruration de l'hafnium (à savoir HfClₓ, notamment HfCl₄ et H₂) dans le gaz vecteur (Argon) (flèche 306) s'effectue sur le sommet du four (307) via un doigt chauffant (308) porté à une température de 500°C, qui vient plonger sur 20 cm environ dans le four (301) et permet d'éviter la condensation des chlorures en entrée de four. Ce doigt (308) est constitué de la ligne de gaz en ¼ pouce revêtue du cordon chauffant de 3 m (voir plus haut), le tout étant isolé du four par la coque en inox du doigt.

Le gaz précurseur méthane (flèche 309) est introduit également au sommet du four (301) par l'intermédiaire d'une canalisation (310).

De même, le gaz réducteur hydrogène (flèche 311) est introduit au sommet du four (301) par l'intermédiaire d'une canalisation (312).

Le mélange des 4 types de gaz à savoir dans le cas du dépôt de HfC les deux gaz précurseurs HfClₓ et CH₄, le gaz réducteur H₂ et le gaz vecteur Argon est assuré par un système de chicanes successives permettant leur homogénéisation.

Plus précisément, des baffles, déflecteurs, par exemple en Papyex^{®} étanche (313) forcent les gaz à traverser des feutres anti-rayonnement (314), puis des mélanges successifs sont assurés par un dispositif de brassage des gaz (315) comprenant des baffles, déflecteurs en graphite.

Le substrat (316) est placé au milieu de la zone chaude du four, par exemple haute d'environ 15cm, qui a été déterminée au préalable par la réalisation d'un profil thermique du four.
- Système de traitement des effluents et des produits gazeux qui n'ont pas réagi.

Le système de traitement et de neutralisation des effluents en provenance du four (101) comprend (voir Figure 1) deux pièges (112, 113) refroidis à l'azote liquide placés en série, en aval du four (101).

Ces pièges (112, 113) permettent de piéger notamment une grande quantité de chlorures métalliques qui n'a pas réagi.

Ces pièges sont isolés du four (101) par une vanne manuelle (114) permettant l'évacuation des effluents en fin d'expérience.

Enfin, un système de pompage constitué par deux pompes disposées en parallèle assure le vide dans le dispositif pendant la mise en oeuvre du procédé, ainsi que le traitement des effluents restants.

Une pompe à palettes (115) est utilisée pour le vide primaire avant et après le procédé de dépôt alors que c'est une pompe sèche (116) qui fonctionne pendant le dépôt.

Les pompes (115, 116) sont reliées au piège (113) par l'intermédiaire d'une canalisation pourvue d'une vanne motorisée (117).
- Gamme et gestion des paramètres expérimentaux.

Dans l'installation pour la mise en ouvre du procédé selon l'invention, il est possible de faire varier plusieurs paramètres qui régissent ce procédé et en particulier la température, la pression et les débits de gaz.

Le contrôle des températures dans l'installation s'effectue en cinq endroits différents à savoir :
- dans le chlorurateur (104) ;
- dans le collier chauffant (211);
- dans les deux cordons chauffants sur la canalisation chauffée et la vanne ;
- dans le four de CVD/CVI (101) où la puissance de chauffage est contrôlée par un régulateur de température.

La pression dans l'ensemble de l'installation est ajustable entre 2kPa et la pression atmosphérique grâce à une vanne papillon motorisée située en amont du système de pompage.

La montée jusqu'à la pression désirée lors de la mise en oeuvre du procédé de dépôt s'effectue grâce une injection progressive d'argon pour ce qui concerne le dépôt de HfC ou bien grâce à une injection progressive d'H₂ pour ce qui concerne le dépôt de SiC.

Il est intéressant de noter qu'un clapet de surpression a été installé en amont du four de chlorurateur en cas de bouchage et que l'ensemble de l'installation est asservie à un arrêt éventuel des gaz et des systèmes de chauffages.

Toutes les valeurs des débits sont commandées par des débitmètres massiques, hormis pour N₂ dont le débit est réglé par un débitmètre à billes.

Le Tableau 1 ci-dessous donne les gammes de débit (L/min) des gaz utilisés dans le procédé selon l'invention.

**Tableau 1 : Gamme de débit (L/min) des gaz utilisés.**

| **Gaz considéré** | **Gamme de débit mini-maxi (L/min)** |
|---|---|
| Méthane | 0-2 |
| Hydrogène | 0-2 |
| Chlorure d'hydrogène | 0-1 |
| Argon (gaz vecteur) | 0-1 |
| Argon (double enveloppe) | 0-4 |
| Méthyltrichlorosilane | 0-0,5 |

Le procédé selon l'invention trouve son application dans tous les domaines où l'on souhaite réaliser des revêtements de protection contre l'oxydation denses et très réfractaires sur des surfaces de pièces.

Le procédé selon l'invention permet l'élaboration de revêtements de protection contre l'oxydation dans des domaines aussi divers que l'aéronautique, l'aérospatiale, l'industrie chimique et d'une manière générale dans tous les domaines où de très hautes températures sont rencontrées.

Dans tous ces domaines, la préparation de protections à l'oxydation, denses et très réfractaires par un procédé de CVD/CVI n'avait jusqu'alors pu être réalisée.

L'invention va maintenant être décrite en référence aux exemples suivants, donnés à titre illustratif et non limitatif.

### EXEMPLES :

### Exemples 1 à 3 :

Dans ces exemples, on prépare trois échantillons dénommés échantillon 1, échantillon 2, et échantillon 3 puis on observe ces échantillons au Microscope Electronique à Balayage (MEB)

Chacun de ces échantillons est constitué par un substrat circulaire d'un diamètre de 15 mm, et d'une épaisseur de 5 mm en matériau composite carbone/carbone (C/C) dense (densité supérieure à 90%) pourvu d'un revêtement de protection contre l'oxydation (PAO) constitué par une alternance de couches de SiC et de HfC.

L'échantillon 1 est un échantillon préparé à des fins de comparaison, par un procédé qui n'est pas conforme au procédé selon l'invention. L'échantillon 1 comprend un substrat n'ayant subi aucun traitement de surface préalablement au dépôt du revêtement, ce substrat étant pourvu d'un revêtement constitué par une alternance de 10 couches de SiC et de HfC.

L'échantillon 2 est identique à l'échantillon 1, à la différence toutefois que dans l'échantillon 2, le substrat a reçu préalablement au dépôt du revêtement un traitement de surface préalable. Le substrat a en effet été revêtu préalablement au dépôt du revêtement d'une couche de catalyseur par simple trempage dans un bain contenant des catalyseurs. L'échantillon 2 diffère en outre de l'échantillon 1 en ce que le revêtement dont est pourvu le substrat ne comprend que 5 couches selon la succession suivante : SiC-HfC-SiC-HfC-SiC.

L'échantillon 3 est identique à l'échantillon 2, à la différence toutefois qu'il est pourvu de cinq couches supplémentaires de SiC et de HfC alternées, soit au total 10 couches de SiC et de HfC alternées.

L'échantillon 3 ne diffère donc de l'échantillon 1 que par le fait que le substrat a reçu préalablement au dépôt du revêtement qui présente le même nombre de couche (10) un traitement de surface préalable.

Les appareils utilisés pour le dépôt des trois revêtements des trois échantillons sont similaires à ceux qui ont été décrits plus haut.

Les paramètres de dépôt utilisés pour le dépôt des trois revêtements des trois échantillons sont identiques.

Ces paramètres de dépôt sont les suivants :
- Pression constante : 5kPa
- Température du substrat : 1000°C
- Débits: Q_{H2/}Q_{MTS}=4 pour les couches de SiC Q_{H2}/Q_{HfCl4}=8,5 pour les couches de HfC
- Temps de dépôt de chaque couche : 2 heures.

Ce qui fait, sans compter les temps de purge, une durée de 10 heures pour réaliser un revêtement de cinq couches.

Les couches de SiC des trois revêtements des trois échantillons sont déposées selon le mode opératoire suivant :
Lorsque le four est à la température de travail de 1000°C, le four étant toujours maintenu sous vide, on ouvre la vanne de H₂ de façon à obtenir une pression dans le four de 5 kPa qui est régulée grâce à la vanne motorisée.

Lorsque cette pression est atteinte, on introduit le MTS.

Au bout d'une durée de deux heures, qui est la durée nécessaire pour obtenir l'épaisseur de dépôt visé de 2 µm, on coupe l'alimentation en gaz réactifs.

On fait ensuite un vide dynamique pendant plusieurs minutes.

Les couches de HfC des trois revêtements des trois échantillons sont déposées selon le mode opératoire suivant :
On ouvre la vanne haute température qui relie le chlorurateur au four CVD, le chlorurateur et les lignes chauffées ayant préalablement été mis en fonctionnement.

On effectue un balayage d'argon de façon à obtenir une pression de 5kPa régulée par la vanne motorisée. Lorsque cette pression est atteinte, on introduit l'hydrogène, puis le méthane et enfin le HCl.

Une durée de 2 heures est nécessaire pour obtenir une épaisseur de dépôt d'environ 2 µm.

On coupe alors toutes les alimentations en gaz réactifs (HCl, CH₄ et H₂).

On effectue ensuite un balayage à l'argon pendant plusieurs minutes puis on fait un vide dynamique pendant une dizaine de minutes avant de déposer une deuxième couche de SiC.

### Exemple 1 (Comparatif).

Dans cet exemple, on prépare l'échantillon 1 tel que décrit plus haut. L'échantillon 1 comprend un substrat n'ayant subi aucun traitement de surface préalablement au dépôt du revêtement, et on dépose sur ce substrat un revêtement constitué par une alternance de 10 couches de SiC et de HfC par le mode opératoire tel que décrit plus haut.

L'épaisseur du revêtement global de 10 couches est de 20 µm.

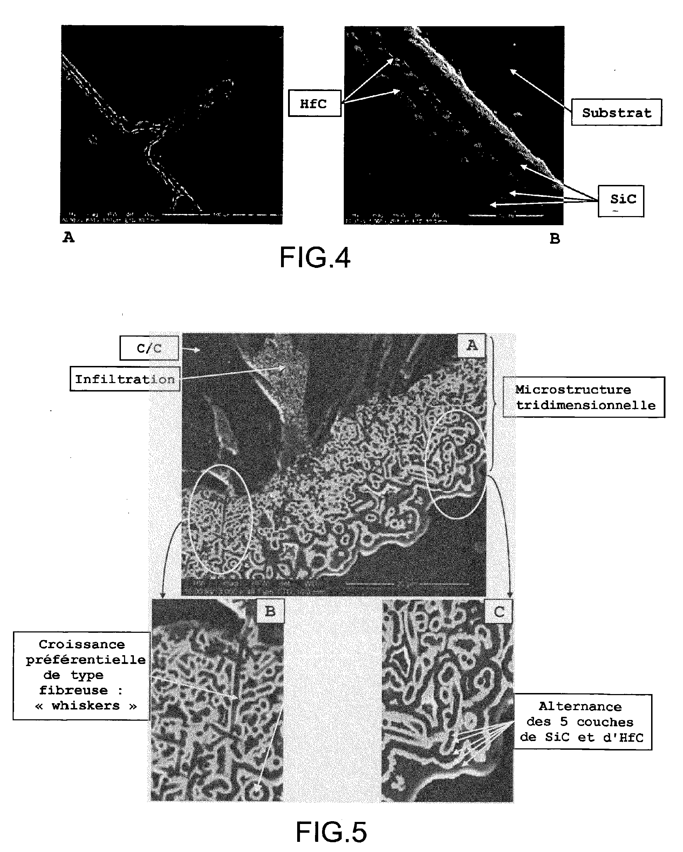

La Figure 4 (A et B) montre des observations en coupe de la microstructure obtenue après cinq couches et indique une bonne intégrité du matériau de 10 µm d'épaisseur pour 5 couches.

Sur la Figure 4B qui est un cliché MEB réalisé avec un grossissement de 5000, le substrat, les trois couches de SiC, et les deux couches de HfC sont clairement visibles.

Il est intéressant de remarquer que l'ensemble du matériau multi-séquencé a pu pénétrer dans les porosités de surface du substrat montrant que les conditions de dépôt employées sont propices à l'infiltration (Figure 4A).

### Exemple 2 (Conforme à l'invention).

Dans cet exemple, on prépare l'échantillon 2 tel que décrit plus haut.

Préalablement au dépôt du revêtement, on commence par revêtir le substrat d'une couche de catalyseur, par simple trempage du substrat pendant 15 minutes dans un bain de catalyseur constitué par une barbotine aqueuse de particules fines (d'une taille de particules de 10 nm à 3µm) de Cu et de Ni.

On dépose ensuite sur ce substrat un revêtement constitué par une alternance de 5 couches de SiC et de HfC par le mode opératoire tel que décrit plus haut.

L'épaisseur du revêtement est de 20 µm.

En d'autres termes, dans cet exemple 5 dépôts alternés de SiC et de HfC sont réalisés comme dans l'exemple 1 sur un substrat en composite C/C identique à celui de l'exemple 1, à la différence que le substrat a subi un traitement de surface dans un bain de catalyseurs de façon à favoriser la création d'une « forêt » de fibres courtes de SiC à la surface du substrat lors de la première étape de dépôt de SiC.

Ce traitement de surface du substrat provoque une croissance plus rapide de la première couche de SiC sous la forme de fibres courtes et de particules fines.

La microstructure de ces dépôts, présentée sur la Figure 5 (A, B, C), est différente de la structure plane obtenue dans le cas de l'échantillon préparé dans l'exemple 1, comparatif, sans traitement de surface (Figure 4).

En effet, un dépôt d'une épaisseur totale d'environ 20 µm est obtenu constitué d'un enchevêtrement de carbure de silicium ayant initialement crû sous diverses formes comme des fibres (Figure 5B) ou de fines particules. Cet ensemble a été, par la suite, recouvert de 4 couches, à savoir 2 couches d'HfC et 2 couches de SiC, les couches de HfC et les couches de SiC étant alternées mettant en évidence la structure multi-séquencée recherchée dans le cadre de l'élaboration d'une PAO (Figure 5C).

Dans l'optique de soumettre ces revêtements à un environnement oxydant, ce traitement a permis d'atteindre des épaisseurs de dépôt global suffisamment élevées (une vingtaine de microns environ contre dix microns sans traitement de surface initial) pour être exposées à des températures très élevées. Ceci a été possible via une croissance préférentielle de la première couche de SiC sous les deux formes exposées plus haut.

Il est également intéressant de noter que ces dépôts successifs ont mené à un revêtement dense.

De plus, on peut remarquer que les conditions d'élaboration utilisées (5kPa et 1000°C) sont favorables à l'infiltration du composite dans les anfractuosités de ce dernier. Il est possible que ce phénomène soit bénéfique à l'adhérence du revêtement dans son ensemble permettant une meilleure résistance en environnement oxydant.

### Exemple 3 (Conforme à l'invention).

Dans cet exemple, on prépare l'échantillon 3 tel que décrit plus haut.

Préalablement au dépôt du revêtement, on commence, comme dans l'exemple 2, par revêtir le substrat d'une couche de catalyseur par simple trempage dans un bain de catalyseur tel que décrit plus haut.

On dépose ensuite sur ce substrat un revêtement identique à celui de l'échantillon 1 constitué par une alternance de 10 couches de SiC et de HfC par le mode opératoire tel que décrit plus haut. L'échantillon 3 est donc identique à l'échantillon 2 mais il a reçu en plus cinq couches supplémentaires de SiC et HfC alternées ; ceci dans le but d'obtenir une PAO optimale présentant une microstructure complexe avec une microstructure tridimensionnelle telle que celle décrite pour l'échantillon 2 et en outre une microstructure multicouche plane telle que celle décrite pour l'échantillon 1.

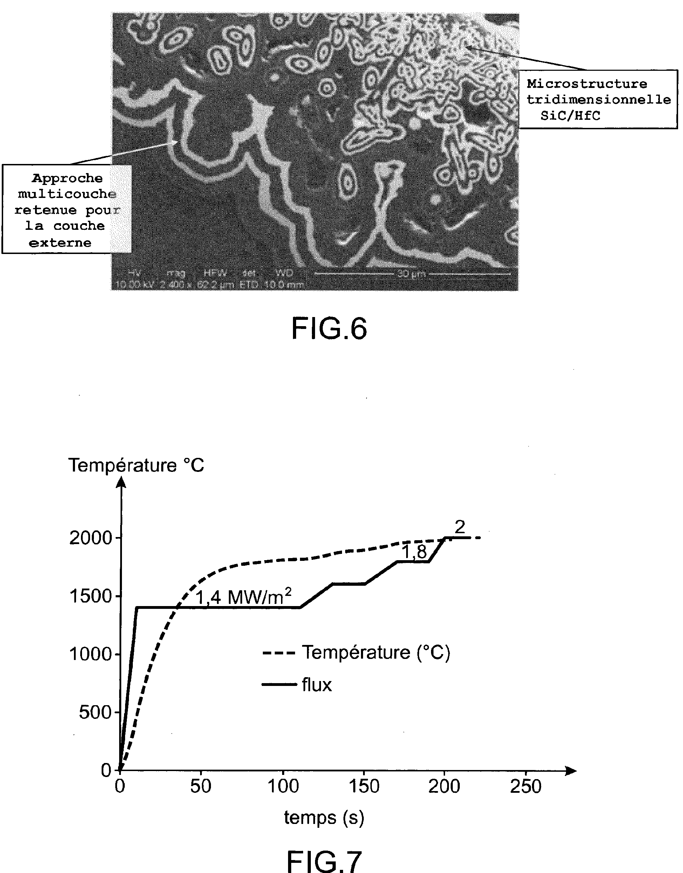

Cette microstructure complexe est présentée sur la Figure 6 où l'on distingue clairement la microstructure tridimensionnelle constituée par les couches alternées de SiC et de HfC et la microstructure multicouche plane externe constituée par les cinq couches supplémentaires de SiC et de HfC alternées.

Même si quelques porosités restent à déplorer (dues à une vitesse de dépôt trop élevée de la 4ème couche de SiC), ce revêtement permet donc de combiner deux concepts de PAO, à savoir :
(1)une alternance 2D étanche et continue pour le multi-séquençage plan des couches de carbures pour la partie externe ;
(2)un mélange 3D plus complexe basé sur l'enchevêtrement de plusieurs structures adhérentes voire pénétrantes dans le substrat.

L'épaisseur totale importante de cette PAO qui est d'environ 50 µm pourra permettre une protection plus efficace dans des conditions de sollicitation extrêmes.

### Exemples 4 à 5 :

Dans ces exemples, on réalise des expériences d'oxydation à haute température, à savoir à une température au-delà de 1500°C, des échantillons 1 et 3 préparés plus haut.

Ces expériences d'oxydation au-delà de 1500°C ont été réalisées par le biais d'un four à images d'arc.

Ce four est équipé de 6 lampes d'une puissance de 7kW chacune, et permet l'irradiation de pièces planes. Il comporte en outre un obturateur pour stopper lorsqu'on le souhaite le flux lumineux émis par les lampes, et un flux mètre pour mesurer ce flux.

Ce dispositif, qui permet d'atteindre des températures sous air de l'ordre de 3000°C, peut fonctionner jusqu'à des densités de flux de 30MW/m² sans limitation dans le temps avec des temps de montée et de descente en flux très rapide, qui sont par exemple de 0,2 à 5 secondes pour la montée en flux et de quelques secondes pour la descente en flux.

Pour l'étude du comportement sous air, les deux échantillons ont été sollicités à une température maximale de 2000°C (-0°C/+50°C).

Les températures sont mesurées à l'aide de thermocouples positionnés au coeur de l'échantillon, dans le substrat, proches de la surface du substrat.

La Figure 7 présente la rampe de pilotage en flux qui a été appliquée à tous les échantillons.

On observe un palier de 100s à 1,4MW/m² puis des paliers de 20s à 1,6 MW/m², à 1,8 MW/m², et à 2 MW/m².

Une caméra permet de suivre en direct l'évolution du matériau. Dès que la PAO est consommée, l'expérience est stoppée.

### Exemple 4 :

Dans cet exemple, on étudie l'oxydation à haute température de l'échantillon N°1 comparatif, et on présente les résultats de cette oxydation.

L'échantillon N°1 qui présente un concept 2D décacouche du type de celui décrit dans le document [10] présente une tenue efficace jusqu'à 1800°C. En effet, il protège efficacement le C/C pendant 160s ce qui correspond à une température maximale de 1800°C (-0°C/+50°C) (voir Fig. 7). Au-delà, la PAO est totalement consommée et le C/C à nu se détériore instantanément.

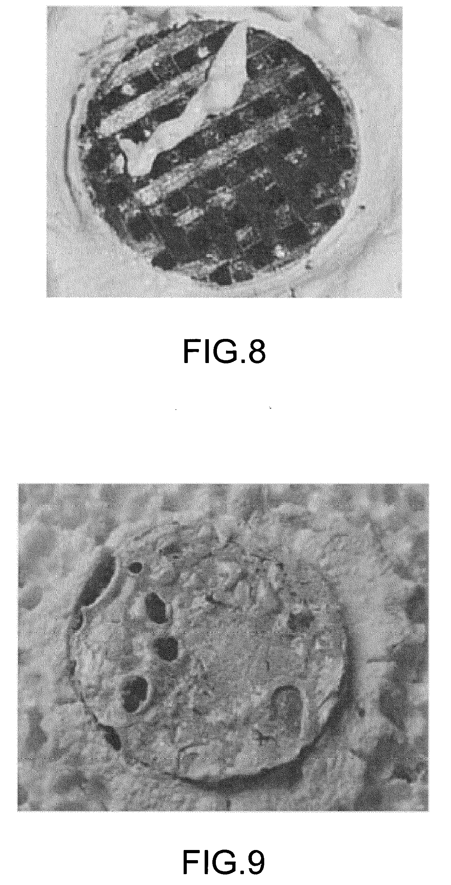

La Figure 8 présente une photographie de l'état de surface du matériau après 160s. Il est possible de distinguer que la quasi-totalité de la PAO a disparu et que le substrat en matériau composite C/C est à nu.

### Exemple 5.

Dans cet exemple, on étudie l'oxydation à haute température de l'échantillon N°3, conforme à l'invention, et on présente les résultats de cette oxydation.

L'échantillon N°3 qui présente une PAO décacouche de type 3D, conforme à l'invention, présente une PAO efficace jusqu'à 2000°C (-0/+50°C). En effet, il protège efficacement le substrat en C/C pendant 205s, temps qui correspond à une température de 2000°C. La Figure 9 présente une photographie de la surface du C/C revêtu sur laquelle il est possible de distinguer la PAO fortement oxydée mais encore adhérente. Cependant, le C/C commence à apparaître.

### RÉFÉRENCES

- [1]: D.W. Mc Kee, Chemistry and Physics of Carbon, Vol. 23, 173 (1991).
- [2]: US-A-3,503,118.
- [3]: FR-A-1475529.
- [4]: WO-A-93/013033.
- [5]: D.W. McKee, Carbon, 25, 551 (1987).
- [6]: US-A-3,775,137.
- [7]: US-A-5,750,450.
- [8]: US-A-4,668,583.
- [9]: K.H. Han, J. Electrochem. Soc. 134, 1003 (1987).
- [10]: R.B. Kaplan et al., US-A-5,283,109 (1994).
- [11]: FR-A-2716208.
- [12]: US-B-6582779
- [13]: CN-A-102 167 623

## Revendications

1. Procédé pour préparer un revêtement multicouche de protection contre l'oxydation sur au moins une surface d'au moins une pièce en au moins un matériau susceptible d'être oxydé, dans lequel on réalise les étapes successives suivantes :
a) on dépose sur la surface une couche d'un catalyseur permettant la croissance de fibres courtes en une céramique qui résiste à l'oxydation ;
b) on fait croître sur la surface, par un procédé de dépôt chimique en phase vapeur CVD ou un procédé d'infiltration chimique en phase vapeur CVI, une première couche constituée par des particules d'une céramique qui résiste à l'oxydation, lesdites particules comprenant une majorité de fibres courtes en une céramique qui résiste à l'oxydation ;
c) on revêt la première couche par un procédé de dépôt chimique en phase vapeur CVD ou un procédé d'infiltration chimique en phase vapeur CVI, de manière totalement homogène, fibre à fibre et sans laisser de porosité, par une deuxième couche en une céramique réfractaire ;
d) on revêt la deuxième couche, par un procédé de dépôt chimique en phase vapeur CVD ou par un procédé d'infiltration chimique en phase vapeur CVI, par une troisième couche en une céramique qui résiste à l'oxydation ;
e) éventuellement, on revêt la troisième couche, par un procédé de dépôt chimique en phase vapeur CVD ou par un procédé d'infiltration chimique en phase vapeur CVI, par une quatrième couche en une céramique réfractaire ;
f) éventuellement on revêt la quatrième couche, par un procédé de dépôt chimique en phase vapeur CVD ou par un procédé d'infiltration chimique en phase vapeur CVI, par une cinquième couche en une céramique qui résiste à l'oxydation ;
g) éventuellement on répète de 1 à 100 fois, de préférence de 1 à 50 fois, les étapes e) et f) ;
h) on récupère la pièce, revêtue sur au moins une de ses surfaces par un revêtement réfractaire de protection contre l'oxydation, ledit revêtement présentant une microstructure tridimensionnelle jusqu'à la troisième couche ou jusqu'à la cinquième couche éventuelle ; la céramique qui résiste à l'oxydation étant différente de la céramique réfractaire.

2. Procédé selon la revendication 1, dans lequel lesdites particules de la première couche comprennent 100% de fibres courtes.

3. Procédé selon la revendication 1 ou 2, dans lequel les fibres courtes comprennent une proportion majoritaire de fibres courtes qui sont sensiblement perpendiculaires, ou perpendiculaires, à la surface, de préférence toutes les fibres courtes sont sensiblement perpendiculaires, ou perpendiculaires, à la surface.

4. Procédé selon l'une quelconque des revendications précédentes, dans lequel le matériau susceptible d'être oxydé est choisi parmi les matériaux à base de carbone tels que les matériaux composites carbone/carbone ; les céramiques telles que les céramiques borures comme HfB₂, les céramiques carbures à l'exception de SiC, comme TiC, ZrC, et HfC, les céramiques nitrures comme TiN et ZrN ; les céramiques composites telles que les céramiques composites SiC/SiC; les métaux ultraréfractaires tels que W ou Ta ; et les composites carbone /céramique tels que les composites C/SiC.

5. Procédé selon l'une quelconque des revendications précédentes, dans lequel le catalyseur permettant la croissance de fibres courtes est choisi parmi les particules de diamant; les particules d'au moins un métal, telles que les particules de Cu, Cr, Fe, Ni, et Al, et les particules de leurs mélanges et alliages.

6. Procédé selon l'une quelconque des revendications précédentes, dans lequel les fibres courtes ont une longueur de 1 nm à 200 µm et un diamètre de 50 nm à 1 µm.

7. Procédé selon l'une quelconque des revendications précédentes, dans lequel la deuxième couche a une épaisseur de 1 nm à 10 µm, de préférence de 100 nm à 5 µm, de préférence encore de 2 à 3 µm ; la troisième couche a une épaisseur de 1 nm à 10 µm, de préférence de 100 nm à 5 µm, de préférence encore de 2 à 3 µm ; la quatrième couche a une épaisseur de 1 nm à 10 µm, de préférence de 100 nm à 5 µm, de préférence encore de 2 à 3 µm ; et la cinquième couche a une épaisseur de 1 nm à 10 µm, de préférence de 100 nm à 5 µm, de préférence encore de 2 à 3 µm.

8. Procédé selon l'une quelconque des revendications précédentes, dans lequel toutes les couches à partir de la deuxième couche ont la même épaisseur.

9. Procédé selon l'une quelconque des revendications précédentes, dans lequel la céramique réfractaire est choisie parmi les céramiques oxydes, les céramiques nitrures, les céramiques borures, les céramiques carbures; leurs mélanges; et les céramiques composites de celles-ci ; de préférence la céramique réfractaire est choisie parmi les carbures de métaux à l'exception de SiC, tels que HfC, ZrC, TiC, TaC, et WC; les mélanges desdits carbures de métaux entre eux, et les mélanges d'un ou plusieurs desdits carbures de métaux avec SiC; les céramiques composites desdits carbures de métaux entre eux, et les céramiques composites d'un ou de plusieurs desdits carbures de métaux avec SiC.

10. Procédé selon l'une quelconque des revendications précédentes, dans lequel la céramique qui résiste à l'oxydation est choisie parmi les céramiques carbures, les céramiques nitrures, les céramiques borures, les céramiques oxydes; leurs mélanges; et les céramiques composites de celles-ci ; la céramique qui résiste à l'oxydation étant différente de la céramique réfractaire ; de préférence la céramique qui résiste à l'oxydation est choisie parmi SiC, TiN, ZrN, HfB₂, ZrB₂; leurs mélanges; et les céramiques composites de celles-ci.

11. Procédé selon l'une quelconque des quelconque des revendications précédentes, dans lequel la céramique qui résiste à l'oxydation est le SiC et la céramique réfractaire est le HfC.

12. Procédé selon l'une quelconque des revendications précédentes, dans lequel les particules de la première couche, la troisième couche, la cinquième couche et les couches en une céramique qui résiste à l'oxydation éventuelles préparées lors de l'étape g) sont constituées par une même céramique, de préférence SiC; et la deuxième couche, la quatrième couche et les couches en une céramique réfractaire éventuelles préparées lors de l'étape g) sont constituées par une même céramique, de préférence HfC.

13. Procédé selon l'une quelconque des revendications précédentes, dans lequel le revêtement réfractaire de protection contre l'oxydation a une épaisseur de 4 nm à 1000 µm, de préférence de 10 nm à 600 µm.

14. Procédé selon l'une quelconque des revendications précédentes, dans lequel les étapes b) à g), sont toutes réalisées en continu dans un même réacteur de dépôt chimique en phase vapeur CVD ou d'infiltration chimique en phase vapeur CVI ; de préférence les étapes b) à g), sont toutes réalisées à une même pression de 0,5 à 50 kPa, par exemple de 5kPa, et une même température de 700°C à 1500°C, par exemple de 1000°C.

15. Revêtement réfractaire multicouche de protection contre l'oxydation comprenant la succession de couches suivante:
- une première couche constituée par des particules d'une céramique qui résiste à l'oxydation, lesdites particules comprenant une majorité de fibres courtes en une céramique qui résiste à l'oxydation ;
- une deuxième couche en une céramique réfractaire qui revêt la première couche de manière totalement homogène, fibre à fibre et sans laisser de porosité ;
- une troisième couche en une céramique qui résiste à l'oxydation ;
- éventuellement, une quatrième couche en une céramique réfractaire ;
- éventuellement une cinquième couche en une céramique qui résiste à l'oxydation ;
- éventuellement une succession, répétée de 1 à 100 fois, de préférence de 1 à 50 fois, d'une couche en une céramique réfractaire et d'une couche en une céramique qui résiste à l'oxydation ;
ledit revêtement présentant une microstructure tridimensionnelle jusqu'à la troisième couche ou jusqu'à la cinquième couche éventuelle ; la céramique qui résiste à l'oxydation étant différente de la céramique réfractaire.

16. Pièce en au moins un matériau susceptible d'être oxydé, revêtue sur au moins une de ses surfaces par un revêtement réfractaire multicouche de protection contre l'oxydation selon la revendication 15.

## Patentansprüche

1. Verfahren zur Herstellung eines multischichtigen Oxidationsschutz-Überzugs auf wenigstens einer Oberfläche eines Bauteils aus wenigstens einem oxidierbaren Material, bei dem man die folgenden sukzessiven Schritte realisiert:
a) man scheidet auf der Oberfläche eine Schicht eines Katalysators ab, die das Wachstum von kurzen Fasern aus einer oxidationsresistenten Keramik ermöglicht;
b) man lässt, durch ein chemisches Gasphasenabscheidungsverfahren CVD oder ein chemisches Gasphaseninfiltrationsverfahren CVI, auf der Oberfläche eine erste Schicht aufwachsen, gebildet durch Teilchen einer oxidationsresistenten Keramik, wobei die genannten Teilchen eine Mehrheit von kurzen Fasern aus einer oxidationsresistenten Keramik umfassen ;
c) man überzieht die erste Schicht, durch ein chemisches Gasphasenabscheidungsverfahren CVD oder ein chemisches Gasphaseninfiltrationsverfahren CVI, auf total homogene Weise, Faser für Faser ohne Porosität zurückzulassen, mit einer zweiten Schicht aus einer refraktären Keramik ;
d) man überzieht die zweite Schicht, durch ein chemisches Gasphasenabscheidungsverfahren CVD oder ein chemisches Gasphaseninfiltrationsverfahren CVI, mit einer dritten Schicht aus einer oxidationsresistenten Keramik ;
e) eventuell überzieht man die dritte Schicht, durch ein chemisches Gasphasenabscheidungsverfahren CVD oder ein chemisches Gasphaseninfiltrationsverfahren CVI, mit einer vierten Schicht aus einer refraktären Keramik ;
f) eventuell überzieht man die vierte Schicht, durch ein chemisches Gasphasenabscheidungsverfahren CVD oder ein chemisches Gasphaseninfiltrationsverfahren CVI, mit einer fünften Schicht aus einer oxidationsresistenten Keramik ;
g) eventuell wiederholt man 1- bis 100 mal, vorzugsweise 1- bis 50 mal, die Schritte e) bis f) ;
h) man bekommt das auf wenigstens einer seiner Oberflächen mit einem refraktären Oxidationsschutz-Überzug beschichtete Bauteil, wobei der genannte Überzug bis zu der dritten Schicht oder bis zu der eventuellen fünften Schicht eine dreidimensionale Mikrostruktur aufweist; die oxidationsresistente Keramik sich dabei von der refraktären Keramik unterscheidet.

2. Verfahren nach Anspruch 1, bei dem die genannten Teilchen der ersten Schicht zu 100 % kurze Fasern umfassen.

3. Verfahren nach Anspruch 1 oder 2, bei dem die kurzen Fasern einen Mehrheitsanteil von kurzen Fasern umfassen, die im Wesentlichen senkrecht, oder senkrecht, zur Oberfläche sind; vorzugsweise sind alle kurzen Fasern im Wesentlichen senkrecht, oder senkrecht, zur Oberfläche.

4. Verfahren nach einem der vorhergehenden Ansprüche, bei dem das oxidierbare-Material ausgewählt wird unter den Materialien auf Kohlenstoffbasis wie zum Beispiel den Kohlenstoff/Kohlenstoff-Verbundstoffmaterialien ; den Keramiken wie zum Beispiel den Boridkeramiken wie HfB₂, den - mit Ausnahme von SiC - Carbidkeramiken wie etwa TiC, ZrC, und HfC, den Nitridkeramiken wie TiN und ZrN ; den Verbundstoffkeramiken wie zum Beispiel den SiC/SiC-Keramiken ; den ultrarefraktären Metallen wie zum Beispiel W oder Ta ; den Kohlenstoff/Keramik-Verbundstoffen wie zum Beispiel den C/SiC-Verbundstoffen.

5. Verfahren nach einem der vorhergehenden Ansprüche, bei dem der das Wachstum der kurzen Fasern ermöglichende Katalysator ausgewählt wird unter Diamantpartikeln ; den Partikeln von wenigstens einem Metall wie zum Beispiel den Partikeln von Cu, Cr, Fe, Ni, und Al, und den Partikeln von ihren Mischungen und Legierungen.

6. Verfahren nach einem der vorhergehenden Ansprüche, bei dem die kurzen Fasern eine Länge von 1 nm bis 200 µm und einen Durchmesser von 50 nm bis 1 µm haben.

7. Verfahren nach einem der vorhergehenden Ansprüche, bei dem die zweite Schicht eine Dicke von 1 nm bis 10 µm, vorzugsweise von 100 nm bis 5 µm, noch bevorzugter von 2 bis 3 µm hat; die dritte Schicht eine Dicke von 1 nm bis 10 µm, vorzugsweise von 100 nm bis 5 µm, noch bevorzugter von 2 bis 3 µm hat; die vierte Schicht eine Dicke von 1 nm bis 10 µm, vorzugsweise von 100 nm bis 5 µm, noch bevorzugter von 2 bis 3 µm hat ; und die fünfte Schicht eine Dicke von 1 nm bis 10 µm, vorzugsweise von 100 nm bis 5 µm, noch bevorzugter von 2 bis 3 µm hat.

8. Verfahren nach einem der vorhergehenden Ansprüche, bei dem alle Schichten ab der zweiten Schicht dieselbe Dicke haben.

9. Verfahren nach einem der vorhergehenden Ansprüche, bei dem die refraktäre Keramik ausgewählt wird unter den Oxidkeramiken, den Nitridkeramiken, den Boridkeramiken, den Carbidkeramiken ; ihren Mischungen ; und den Verbundstoffkeramiken von diesen ; vorzugsweise wird die refraktäre Keramik ausgewählt unter den - mit Ausnahme von SiC - Metallcarbiden wie zum Beispiel HfC, ZrC, TiC, TaC, und WC, den Mischungen der genannten Metallcarbide untereinander, und den Mischungen von einem oder mehreren der genannten Metallcarbide mit SiC ; den Verbundstoffkeramiken der genannten Metallcarbide untereinander, und den Verbundstoffkeramiken von einem oder mehreren der genannten Metallcarbide mit SiC.

10. Verfahren nach einem der vorhergehenden Ansprüche, bei dem die Keramik, die der Oxidation widersteht, ausgewählt wird unter den Carbidkeramiken, den Nitridkeramiken, den Boridkeramiken, den Oxidkeramiken ; ihren Mischungen ; und den Verbundstoffkeramiken von diesen ; wobei die der Oxidation widerstehende Keramik sich von der refraktären Keramik unterscheidet ; vorzugsweise die der Oxidation widerstehende Keramik ausgewählt wird unter SiC, TiN, ZrN, HfB₂, ZrB₂ ; ihren Mischungen ; und den Verbundstoffkeramiken von diesen.

11. Verfahren nach einem der vorhergehenden Ansprüche, bei dem die Keramik, die der Oxidation widersteht, das SiC ist, und die refraktäre Keramik das HfC ist.

12. Verfahren nach einem der vorhergehenden Ansprüche, bei dem die Teilchen der ersten Schicht, der dritten Schicht, der fünften Schicht und den Schichten aus einer oxidationsresistenten Keramik, eventuell hergestellt während des Schrittes g), durch eine gleiche Keramik gebildet werden, vorzugsweise SiC ; und die zweite Schicht, die vierte Schicht und die Schichten aus einer refraktären Keramik, eventuell hergestellt während des Schritts g), durch eine gleiche Keramik gebildet werden, vorzugsweise HfC.

13. Verfahren nach einem der vorhergehenden Ansprüche, bei dem der refraktäre Oxidationsschutz-Überzug eine Dicke von 4 nm bis 1000 µm, vorzugsweise von 10 nm bis 600 µm hat.

14. Verfahren nach einem der vorhergehenden Ansprüche, bei dem die Schritte b) bis g) alle kontinuierlich in demselben CVD- oder CVI-Reaktor realisiert werden ; vorzugsweise werden die Schritte b) bis g) alle bei einem gleichen Druck von 0,5 bis 50 kPa, zum Beispiel 5 kPa, und einer gleichen Temperatur von 700 °C bis 1500 °C, zum Beispiel 1000 °C, durchgeführt.

15. Refraktärer multischichtiger Oxidationsschutz-Überzug, umfassend die Aufeinanderfolge von folgenden Schichten:
- eine erste Schicht, gebildet durch Teilchen einer oxidationsresistenten Keramik, wobei die genannten Teilchen eine Mehrheit von kurzen Fasern aus einer oxidationsresistenten Keramik umfassen ;
- eine zweite Schicht aus einer refraktären Keramik, welche die erste Schicht Faser für Faser auf total homogene Weise überzieht, ohne Porosität zurück zu lassen ;
- eine dritte Schicht aus einer oxidationsresistenten Keramik ;
- eventuell eine vierte Schicht aus einer refraktären Keramik ;
- eventuell eine fünfte Schicht aus einer oxidationsresistenten Keramik ;
- eventuell eine 1- bis 100mal, vorzugsweise 1- bis 50mal repetierte Aufeinanderfolge einer Schicht aus einer refraktären Keramik und einer Schicht aus einer oxidationsresistenten Keramik ;
wobei der genannte Überzug bis zu der dritten Schicht oder bis zu der eventuellen fünften Schicht eine dreidimensionale Mikrostruktur aufweist ; die oxidationsresistente Keramik sich dabei von der refraktären Keramik unterscheidet.

16. Bauteil aus einem oxidierbaren Material, das auf wenigstens einer seiner Oberflächen mit einem refraktären multischichtigen Oxidationsschutz-Überzug nach Anspruch 15 beschichtet ist.

## Claims

1. Method for preparing a multilayer coating for protecting against oxidation on at least one surface of at least one part made of at least one material capable of being oxidized, in which the following successive steps are carried out:
a) on the surface is deposited a layer of a catalyst enabling the growth of short fibres made of a ceramic that resists oxidation;
b) on the surface is grown, using a chemical vapour deposition CVD method or a chemical vapour infiltration CVI method, a first layer constituted of particles of a ceramic that resists oxidation, said particles comprising a majority of short fibres made of a ceramic that resists oxidation;
c) the first layer is coated, using a chemical vapour deposition CVD method or a chemical vapour infiltration CVI method, in a totally homogeneous manner, fibre by fibre and without leaving any porosity, with a second layer made of a refractory ceramic;
d) the second layer is coated, using a chemical vapour deposition CVD method or a chemical vapour infiltration CVI method, with a third layer made of a ceramic that resists oxidation;
e) optionally, the third layer is coated, using a chemical vapour deposition CVD method or a chemical vapour infiltration CVI method, with a fourth layer made of a refractory ceramic;
f) optionally the fourth layer is coated, using a chemical vapour deposition CVD method or a chemical vapour infiltration CVI method, with a fifth layer made of a ceramic that resists oxidation;
g) optionally steps e) and f) are repeated 1 to 100 times, preferably 1 to 50 times;
h) the part, coated on at least one of its surfaces with a refractory coating for protecting against oxidation, is recovered, said coating having a three-dimensional microstructure up to the third layer or up to the optional fifth layer; the ceramic that resists oxidation being different to the refractory ceramic.

2. Method according to claim 1, in which said particles of the first layer comprise 100% short fibres.

3. Method according to claim 1 or 2, in which the short fibres comprise a majority proportion of short fibres that are substantially perpendicular, or perpendicular, to the surface, preferably all the short fibres are substantially perpendicular, or perpendicular, to the surface.

4. Method according to any one of the preceding claims, in which the material capable of being oxidized is selected from materials based on carbon such as carbon/carbon composite materials; ceramics such as boride ceramics like HfB₂, carbide ceramics with the exception of SiC, like TiC, ZrC, and HfC, nitride ceramics such as TiN and ZrN; composite ceramics such as SiC/SiC composite ceramics; ultrarefractory metals such as W or Ta; and carbon/ceramic composites such as C/SiC composites.

5. Method according to anyone of the preceding claims, in which the catalyst enabling the growth of short fibres is selected from particles of diamond; particles of at least one metal, such as particles of Cu, Cr, Fe, Ni, and Al, and particles of mixtures and alloys thereof.

6. Method according to any one of the preceding claims, in which the short fibres have a length of 1 nm to 200 µm and a diameter of 50 nm to 1 µm.

7. Method according to any one of the preceding claims, in which the second layer has a thickness of 1 nm to 10 µm, preferably 100 nm to 5 µm, even more preferably 2 to 3 µm; the third layer has a thickness of 1 nm to 10 µm, preferably 100 nm to 5 µm, even more preferably 2 to 3 µm; the fourth layer has a thickness of 1 nm to 10 µm, preferably 100 nm to 5 µm, even more preferably 2 to 3 µm; and the fifth layer has a thickness of 1 nm to 10 µm, preferably 100 nm to 5 µm, even more preferably 2 to 3 µm.

8. Method according to any one of the preceding claims, in which all the layers from the second layer have the same thickness.

9. Method according to any one of the preceding claims, in which the refractory ceramic is selected from oxide ceramics, nitride ceramics, boride ceramics, carbide ceramics; mixtures thereof; and composite ceramics thereof; preferably the refractory ceramic is selected from metal carbides with the exception of SiC, such as HfC, ZrC, TiC, TaC, and WC; mixtures of said metal carbides with each other, and mixtures of one or more of said metal carbides with SiC; composite ceramics of said metal carbides with each other, and composite ceramics of one or more of said metal carbides with SiC.

10. Method according to any one of the preceding claims, in which the ceramic that resists oxidation is selected from carbide ceramics, nitride ceramics, boride ceramics, oxide ceramics; mixtures thereof; and composite ceramics thereof; the ceramic that resists oxidation being different to the refractory ceramic; preferably the ceramic that resists oxidation is selected from SiC, TiN, ZrN, HfB₂, ZrB₂; mixtures thereof; and composite ceramics thereof.

11. Method according to any one of the preceding claims, in which the ceramic that resists oxidation is SiC and the refractory ceramic is HfC.

12. Method according to any one of the preceding claims, in which the particles of the first layer, the third layer, the fifth layer and the optional layers made of a ceramic that resists oxidation prepared during step g) are constituted of a same ceramic, preferably SiC; and the second layer, the fourth layer and the optional layers made of a refractory ceramic prepared during step g) are constituted of a same ceramic, preferably HfC.

13. Method according to any one of the preceding claims, in which the refractory coating for protecting against oxidation has a thickness of 4 nm to 1000 µm, preferably 10 nm to 600 µm.

14. Method according to any one of the preceding claims, in which steps b) to g) are all carried out continuously in a same chemical vapour deposition CVD or chemical vapour infiltration CVI reactor; preferably steps b) to g), are all carried out at a same pressure of 0.5 to 50 kPa, for example 5kPa, and at a same temperature of 700°C to 1500°C, for example 1000°C.

15. Refractory multilayer coating for protecting against oxidation comprising the following succession of layers:
- a first layer constituted of particles of a ceramic that resists oxidation, said particles comprising a majority of short fibres made of a ceramic that resists oxidation;
- a second layer made of a refractory ceramic that coats the first layer in a totally homogeneous manner, fibre by fibre and without leaving any porosity;
- a third layer made of a ceramic that resists oxidation;
- optionally, a fourth layer made of a refractory ceramic;
- optionally a fifth layer made of a ceramic that resists oxidation;
- optionally a succession, repeated 1 to 100 times, preferably 1 to 50 times, of a layer made of a refractory ceramic and a layer made of a ceramic that resists oxidation;
said coating having a three-dimensional microstructure up to the third layer or up to the optional fifth layer; the ceramic that resists oxidation being different to the refractory ceramic.

16. Part made of at least one material capable of being oxidized, coated on at least one of its surfaces with a refractory multilayer coating for protecting against oxidation according to claim 15.
